(19) Europäisches Patentamt
European Patent Office
Office européen des brevets

(11) EP 4 773 768 A1

(12) EUROPEAN PATENT APPLICATION
published in accordance with Art. 153(4) EPC

(43) Date of publication:
08.07.2026 Bulletin 2026/28

(21) Application number: 24870319.1

(22) Date of filing: 29.08.2024

(51) International Patent Classification (IPC):
H10K 59/12 (2023.01)    H10K 59/121 (2023.01)
H10K 59/131 (2023.01)    H10K 59/126 (2023.01)

(52) Cooperative Patent Classification (CPC):
H10D 86/60; H10K 59/12; H10K 59/121;
H10K 59/126; H10K 59/131

(86) International application number:
PCT/CN2024/115594

(87) International publication number:
WO 2025/066773 (03.04.2025 Gazette 2025/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 26.09.2023 CN 202311258013

(71) Applicants:
• BOE Technology Group Co., Ltd.
Beijing 100015 (CN)
• Chengdu BOE Optoelectronics Technology Co.,
Ltd.
Chengdu, Sichuan 611731 (CN)

• Beijing BOE Technology Development Co., Ltd.
Daxing District
Beijing 100176 (CN)

(72) Inventors:
• WANG, Rong
Beijing 100176 (CN)
• LIU, Tingliang
Beijing 100176 (CN)
• HUANG, Yao
Beijing 100176 (CN)
• LIU, Zhen
Beijing 100176 (CN)

(74) Representative: Potter Clarkson
Chapel Quarter
Mount Street
Nottingham NG1 6HQ (GB)

(54) **DISPLAY PANEL AND DISPLAY DEVICE**

(57) A display panel and a display device, relating to the technical field of display. The display panel comprises a driving backplane (BP) and a light-emitting device (LD); the driving backplane (BP) comprises a plurality of pixel circuits (PC) distributed in an array along a row direction and a column direction; the pixel circuits (PC) each comprise a plurality of transistors, and the transistors in any pixel circuit (PC) include a driving transistor (T5); the driving transistor (T5) and at least some of the other transistors in any pixel circuit (PC) are metal oxide transistors; the driving backplane (BP) comprises a substrate (SU), and a semiconductor layer (SE) and at least one source/drain layer which are distributed in a direction distant from the substrate; channel portions of at least some of the transistors are located in the semiconductor layer (SE); the source/drain layer overlaps with channel portions of at least some of the metal oxide transistors; the light-emitting device (LD) is disposed on one side of the driving backplane (BP), and comprises a first electrode (ANO), a light-emitting layer (EL), and a second electrode (CAT) which are distributed in a direction distant from the driving backplane (BP); and a first electrode of the driving transistor (T5) is connected to the first electrode (ANO) of the light-emitting device (LD).

FIG. 4

EP 4 773 768 A1

**Description**

**CROSS REFERENCE**

The present disclosure claims the priority of the Chinese Patent Application No. 202311258013.4, titled "DISPLAY PANEL AND DISPLAY DEVICE", filed on September 26, 2023, which is incorporated herein by reference in its entirety.

**TECHNICAL FIELD**

The present disclosure relates to the field of display technology, and specifically, to a display panel and a display device.

**BACKGROUND**

For display panels that employ organic light emission diodes as the light emission components, their luminance is typically controlled by pixel circuits. If the pixel circuits utilize metal oxide transistors, they are susceptible to threshold voltage shifts under the influence of light, thereby affecting the picture quality.

It should be noted that the information disclosed in the above-mentioned background technology section is solely for enhancing the understanding of the background of the present disclosure and may encompass information that does not constitute the prior art known to those skilled in the art.

**SUMMARY**

The present disclosure provides a display panel and a display device.

According to one aspect of the present disclosure, a display panel is provided, including:

a driving backplane, including a plurality of pixel circuits arrayed in a row direction and a column direction, where the pixel circuit includes a plurality of transistors, and a transistor in any of the pixel circuits includes a driving transistor; the driving transistor in any of the pixel circuits and at least part of the transistors other than the driving transistor are metal oxide transistors; the driving backplane includes a substrate, and a semiconductor layer and at least one source-drain layer distributed along a direction away from the substrate; a channel part of at least part of the transistors is located in the semiconductor layer; the source-drain layer overlaps with a channel part of at least part of the metal oxide transistors; and

a light emission device, provided on one side of the driving backplane and including a first electrode, a light emission layer and a second electrode distributed along a direction away from the driving backplane; where a first terminal of the driving transistor is connected to the first electrode of the light emission device.

In an exemplary embodiment of the present disclosure, the pixel circuit further includes a storage capacitor, and the transistor in the pixel circuit further includes a first reset circuit, a second reset circuit, a write circuit and a light emission control circuit;

the first reset circuit is connected to a gate of the driving transistor, and configured to transmit a first reset signal in response to a first reset scan signal; the second reset circuit is connected to the first terminal of the driving transistor, and configured to transmit a second reset signal in response to a second reset scan signal; the write circuit is connected to the gate of the driving transistor, and configured to transmit a data signal in response to a write scan signal; the light emission control circuit is configured to receive a first power signal, connected to a second terminal of the driving transistor, and configured to be conductive in response to a light emission control signal; and the storage capacitor is connected to the first terminal and the gate of the driving transistor.

In an exemplary embodiment of the present disclosure, the driving backplane further includes a first power line and a data line extending along the column direction, and a first reset scan line, a second reset scan line, a write scan line, a light emission control line, a first reset signal line and a second reset signal line extending along the row direction;

the first reset circuit includes a first reset transistor, the second reset circuit includes a second reset transistor, the write circuit includes a write transistor, and the light emission control circuit includes a light emission control transistor; all the transistors in the pixel circuit are metal oxide transistors;

the first reset scan line is connected to a gate of the first reset transistor, and configured to transmit the first reset scan signal; the first reset signal line is connected to the gate of the driving transistor through the first reset transistor, and configured to transmit the first reset signal;

the second reset scan line is connected to a gate of the second reset transistor, and configured to transmit the second reset scan signal; the second reset signal line is connected to the first terminal of the driving transistor through the second reset transistor, and configured to transmit the second reset signal;

the first power line is connected to the second terminal of the driving transistor through the light emission control transistor, and configured to transmit the first power signal;

the write scan line is connected to a gate of the write transistor, and configured to transmit the write scan signal; the data line is connected to the gate of the driving transistor through the write transistor, and configured to transmit the data signal;

the light emission control line is connected to a gate of the light emission control transistor, and configured to transmit the light emission control signal.

In an exemplary embodiment of the present disclosure, the driving backplane further includes a second power line extending along the column direction, and a first auxiliary power line and a second auxiliary power line extending along the row direction;

the first auxiliary power line and the first power line are located on different layers and are connected through a contact hole;

the second power line and the second auxiliary power line are located on different layers and are connected through a contact hole; the second power line is connected to the second electrode, and configured to transmit a second power signal.

In an exemplary embodiment of the present disclosure, the driving backplane further includes a first auxiliary reset line extending along the column direction, the first auxiliary reset line and the first reset signal line are located on different layers and are connected through a contact hole.

In an exemplary embodiment of the present disclosure, the driving backplane further includes a second auxiliary reset line extending along the column direction, the second auxiliary reset line and the second reset signal line are located on different layers and are connected through a contact hole.

In an exemplary embodiment of the present disclosure, one data line is connected to a write transistor of one column of the pixel circuits; one first power line is connected to a light emission control transistor of one column of the pixel circuits;

a data line and a first power line connected to a same column of the pixel circuits are defined as a column line group YG, where one of the second power line, the first auxiliary reset line and the second auxiliary reset line is provided between two adjacent column line groups.

In an exemplary embodiment of the present disclosure, one row of the pixel circuits is simultaneously connected to one first reset scan line, one second reset scan line, one write scan line, one light emission control line, one first reset signal line and one second reset signal line;

the first reset scan line, the second reset scan line, the write scan line, the light emission control line, the first reset signal line and the second reset signal line connected to a same row of the pixel circuit are defined as a row line group; one first auxiliary power line and one second auxiliary power line are provided between two adjacent row line groups.

In an exemplary embodiment of the present disclosure, the source-drain layer includes a first source-drain layer and a second source-drain layer distributed along the direction away from the substrate;

a channel part of the write transistor and a channel part of the second reset transistor overlap with the first source-drain layer; a channel part of the first reset transistor and a channel part of the light emission control transistor overlap with the second source-drain layer.

In an exemplary embodiment of the present disclosure, the semiconductor layer includes a first semiconductor part and a second semiconductor part distributed at intervals along the row direction, and the first semiconductor part and the second semiconductor part extend along the row direction;

a channel part of the first reset transistor and a channel part of the write transistor are located along the column direction in the first semiconductor part; the channel part of the light emission control transistor, the channel part of the driving transistor and the channel part of the second reset transistor are located along the column direction in the second semiconductor part;

the channel part of the write transistor overlaps with one write scan line; the channel part of the second reset transistor overlaps with one second reset scan line;

the first power line overlaps with the channel part of the light emission control transistor, the second reset transistor, and the driving transistor and.

In an exemplary embodiment of the present disclosure, a boundary, in the row direction, of an orthographic projection of at least a partial region of the second semiconductor part on the substrate is located within a boundary, in the row direction, of an orthographic projection of the first power line on the substrate.

In an exemplary embodiment of the present disclosure, the boundary, in the row direction, of the orthographic projection of the at least partial region of the second semiconductor part on the substrate is defined as a first boundary, and the boundary, in the row direction, of the orthographic projection of the first power line on the substrate is defined as a second boundary;

the first boundary is located inside the second boundary, and a distance between the first boundary and the second boundary is less than 2μm.

In an exemplary embodiment of the present disclosure, the first reset scan line, the second reset scan line, the write scan line, the light emission control line, the first reset signal line, the second reset signal line, the first auxiliary power line and the second auxiliary power line are located in the first source-drain layer;

the first power line, the second power line, the data line, the first auxiliary reset line and the second auxiliary reset line are located in the second source-drain layer.

In an exemplary embodiment of the present disclosure, the driving backplane further includes:

a light-shielding layer, located on one side of the substrate and including a light-shielding part; where the semiconductor layer is located on one side of the light-shielding layer away from the substrate, the light-shielding part overlaps with a channel part of the driving transistor, and the light-shielding part is reused as a first terminal plate of the storage capacitor;

a first gate layer, located on the side of the light-shielding layer away from the substrate and including a second terminal plate of the storage capacitor; where the semiconductor layer is located on one side of the first gate layer away from the substrate, and the first terminal plate overlaps with the channel part of the driving transistor; and

a second gate layer, located on one side of the semiconductor layer away from the substrate and overlapping with the channel part of the driving transistor; where the first source-drain layer is located on one side of the second gate layer away from the substrate.

In an exemplary embodiment of the present disclosure, the first gate layer further includes a first gate part, a second gate part, a third gate part and a fourth gate part; the second gate layer includes a fifth gate part, a sixth gate part, a seventh gate part, an eighth gate part and a ninth gate part;

the first gate part and the fifth gate part overlap with the channel part of the first reset transistor, and the first gate part and the fifth gate part are connected;

the second gate part and the sixth gate part overlap with the channel part of the write transistor, and the second gate part and the sixth gate part are connected;

the third gate part and the seventh gate part overlap with the channel part of the light emission control transistor, and the third gate part and the seventh gate part are connected;

the fourth gate part and the eighth gate part overlap with the channel part of the second reset transistor, and the fourth gate part and the eighth gate part are connected;

the ninth gate part overlaps with the channel part of the driving transistor.

In an exemplary embodiment of the present disclosure, a boundary, in the column direction, of an orthographic projection of the first gate part and the fifth gate part on the substrate, is located within a boundary, in the column direction, of an orthographic projection of one of the second power line, the first auxiliary reset line and the second auxiliary reset line on the substrate; and the first gate part and the fifth gate part are connected to the first reset scan line;

a boundary, in the column direction, of an orthographic projection of the third gate part and the seventh gate part on the substrate is within a boundary, in the column direction, of an orthographic projection of the first power line on the substrate; and the third gate part and the seventh gate part are connected to the light emission control line;

a boundary, in the column direction, of an orthographic projection of the second gate part and the sixth gate on the substrate is within a boundary, in the column direction, of an orthographic projection of the write scan line on the substrate; and the second gate part and the sixth gate part are connected to the first reset scan line;

a boundary, in the column direction, of an orthographic projection of the fourth gate part and the eighth gate part on the substrate is within a boundary, in the column direction, of an orthographic projection of the second reset scan line on the substrate; and the fourth gate part and the eighth gate part are connected to the second reset scan line.

In an exemplary embodiment of the present disclosure, one first electrode at least overlaps with a channel part of one of the driving transistors.

In an exemplary embodiment of the present disclosure, the first electrode includes an electrode body and an extension part connected to an edge of the electrode body, where one extension part is connected to the first terminal of one of the driving transistors;

at least a part of the first electrodes further includes an extension part connected to the edge of the electrode body, where the extension part overlaps with the channel part of the driving transistor;

the display panel further includes:

a pixel defining layer, provided on a same side of the driving backplane as the light emission device and having a pixel opening exposing each of the first electrodes; a boundary of an orthographic projection of the pixel opening on the substrate is within a boundary of the electrode body of the first electrode exposed by the pixel opening.

In an exemplary embodiment of the present disclosure, at least a part of the first electrode overlaps with channel parts of a plurality of driving transistors.

According to one aspect of the present disclosure, a display device is provided, including the display panel as described in any one of the above embodiments.

It should be understood that the foregoing general description and the following detailed description are exemplary and explanatory only, and do not limit the present disclosure.

## BRIEF DESCRIPTION OF THE DRAWINGS

The accompanying drawings, which are incorporated in and constitute a part of this specification, illustrate embodiments consistent with the disclosure and together with the description serve to explain the principles of the present invention. It is to be noted that the drawings in the following description are only some embodiments of this disclosure, and those skilled in the art can obtain other drawings according to the present drawings without creative efforts.

FIG. 1 is a top view schematic diagram of a display panel according to an embodiment of the present disclosure.

FIG. 2 is a cross-sectional schematic diagram of a display panel according to an embodiment of the present disclosure.

FIG. 3 is a schematic diagram of the pixel opening of a display panel according to an embodiment of the present disclosure.

FIG. 4 is a schematic diagram of the pixel circuit of a display panel according to an embodiment of the present disclosure.

FIG. 5 is a driving timing diagram of the pixel circuit of a display panel according to an embodiment of the present disclosure.

FIG. 6 is a schematic diagram of the pixel circuit in the initialization stage of a display panel according to an embodiment of the present disclosure.

FIG. 7 is a schematic diagram of the pixel circuit in the compensation stage of a display panel according to an embodiment of the present disclosure.

FIG. 8 is a schematic diagram of the pixel circuit in the write stage of a display panel according to an embodiment of the present disclosure.

FIG. 9 is a schematic diagram of the pixel circuit in the light emission stage of a display panel according to an embodiment of the present disclosure.

FIG. 10 is a partial top view of a display panel according to an embodiment of the present disclosure.

FIG. 11 is a partial top view of the shielding layer to the second source-drain layer of a display panel according to an embodiment of the present disclosure.

FIG. 12 is a partial top view of the shielding layer to the first source-drain layer of a display panel according to an embodiment of the present disclosure.

FIG. 13 is a cross-sectional view of A-A in FIG. 12.

FIG. 14 is a cross-sectional view of B-B in FIG. 12.

FIG. 15 is a cross-sectional view of C-C in FIG. 12.

FIG. 16 is a partial top view of the shielding layer to the second gate layer of a display panel according to an embodiment of the present disclosure.

FIG. 17 is a partial top view of the first gate layer to the second gate layer of a display panel according to an embodiment of the present disclosure.

FIG. 18 is a partial top view of the first gate layer and the semiconductor layer of a display panel according to an embodiment of the present disclosure.

FIG. 19 is a partial top view of the semiconductor layer and the second gate layer of a display panel according to an embodiment of the present disclosure.

FIG. 20 is a partial top view of the light shielding layer and the first gate layer of a display panel according to an embodiment of the present disclosure.

FIG. 21 to FIG. 26 are partial top views of a plurality of film layers of the display panel of the present disclosure respectively.

FIG. 27 is a top view of the first electrode of a display panel according to an embodiment of the present disclosure.

FIG. 28 is a partial top view of the first power line and the second semiconductor part of a display panel according to an embodiment of the present disclosure.

FIG. 29 is a partial top view of the display panel according to another embodiment of the present disclosure.

FIG. 30 is a partial top view of the light shielding layer to the second source-drain layer of the display panel according to another embodiment of the present disclosure.

## DETAILED DESCRIPTION

Exemplary embodiments will now be described in more detail with reference to the accompanying drawings. However, the exemplary embodiments can be implemented in various forms and should not be construed as being limited to the embodiments described herein; rather, these embodiments are provided to make the disclosure complete and comprehensive and to convey the full scope of the inventive concept to those skilled in the art. The same reference numerals in the drawings denote the same or similar structures, and thus their detailed descriptions will be omitted. Additionally, the drawings are merely schematic illustrations of the present disclosure and are not necessarily drawn to scale.

The terms "a", "one", "the", "said", and "at least one" are used for indicating the existence of one or more elements/components/and the like; the terms "including" and "having" are used for indicating an open-ended inclusive meaning and refer to the possibility of the existence of additional elements/components/and the like other than those listed; the terms "first", "second", and "third" and the like are used merely as labels and do not impose any numerical limitation on their objects.

In the present article, the row direction X and the column direction Y are two intersecting directions, the row direction X and the column direction Y can be mutually perpendicular. In the attached drawings of the present disclosure, the row direction X is horizontal and the column direction Y is vertical, but they are not limited thereto. It is known to those skilled in the art that if the display panel rotates, the actual orientation of the row direction X and the column direction Y may change.

In the present article, "overlap" of A and B refers to the situation where the orthographic projections of A and B on the substrate at least partially coincide. It can further mean that the orthographic projections of A and B on a plane parallel to the substrate at least partially overlap. In the present article, A and B are located on "different layers" means that A and B are different film layers formed at different times.

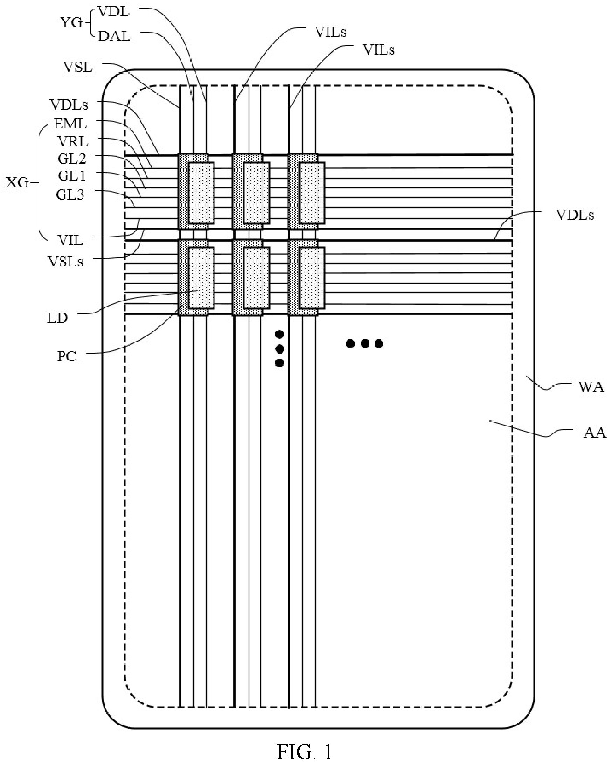

The present disclosure provides a display panel, as shown in FIG. 1, which may include a display area AA and a peripheral area WA located outside the display area AA. The peripheral area WA may be a continuous annular area surrounding the display area AA, or it may be a discontinuous area outside the display area AA.

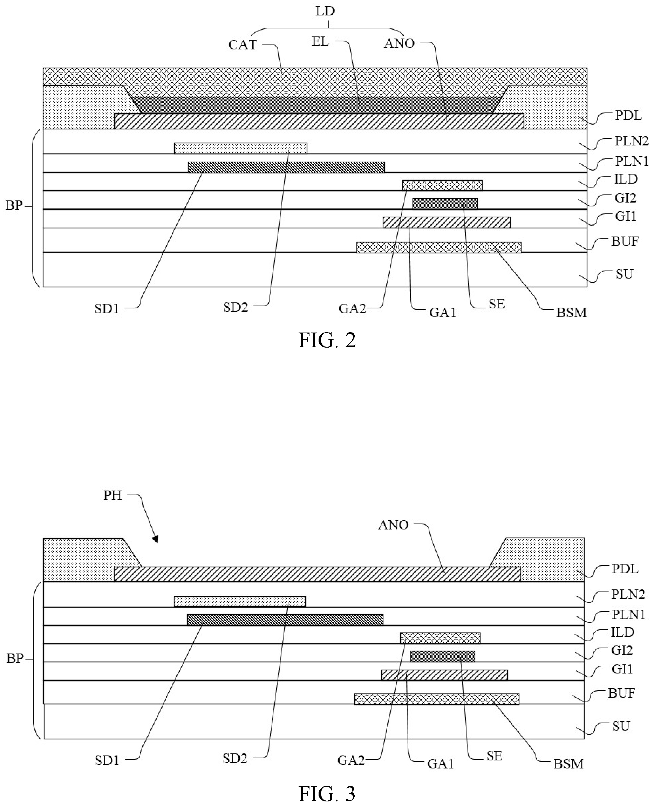

As shown in FIG. 2, the display panel may include a driving backplane BP and a plurality of light emission devices LD arranged on one side of the driving backplane BP. Each light emission device LD may be arrayed in a row direction X and a column direction Y. The light emission devices LD can be driven to emit light by a driving circuit in the driving backplane BP to display images.

As shown in FIG. 1 and FIG. 2, the light emission devices LD may be located in the display area AA. They may be OLEDs (organic light emission diodes) made of organic light emission materials; or they may be LEDs (light emission diodes) made of inorganic light emission materials, such as Micro LEDs (micron-sized light emission diodes) and Mini LEDs (sub-millimeter light emission diodes); or they may be QLEDs (quantum dot diodes) and other devices. Here, no specific structure of the light emission devices LD is particularly limited.

As shown in FIG. 2 and FIG. 3, taking the light emission device LD implemented by OLED as an example, which may include a first electrode ANO, a light emission layer EL, and a second electrode CAT stacked in sequence along a direction away from the driving backplane BP. By applying a first power signal VDD to the first electrode ANO and a second power signal VSS to the second electrode CAT, the light emission layer EL can be excited to emit light. The specific principle is not elaborated here. Meanwhile, to define the range of the light emission devices LD, a pixel definition layer PDL can be provided on the driving backplane BP. The pixel definition layer PDL and the first electrode ANO are located on the same surface of the driving backplane BP, and the pixel definition layer PDL may have pixel openings PH exposing each first electrode ANO, thereby defining the range of the light emission devices LD through each pixel opening PH.

The driving circuit may include pixel circuits PC located in the display area AA and peripheral circuits located in the peripheral area WA. The pixel circuits PC may be arrayed in the row direction X and the column direction Y. One pixel circuit PC may be connected to the first electrode ANO of one light emission device LD. One pixel circuit PC may alternatively be connected to the first electrodes ANO of a plurality of light emission devices LD.

The peripheral circuits can be connected to the light emission devices LD through the pixel circuits PC to apply the first power signal VDD to the first electrode ANO of the light emission devices LD. The peripheral circuits may further include a gate driver circuit for scanning the pixel circuits PC, a light emission driver circuit, and the like. Meanwhile, the peripheral circuits may further be connected to the second electrode CAT of the light emission devices LD and apply the second power signal VSS to the second electrode CAT. Through the pixel circuits PC, the current passing through the light emission devices LD can be controlled, thereby controlling the brightness of the light emission devices LD.

The pixel circuit PC may include a plurality of transistors. The transistors of any pixel circuit PC at least include a driving transistor T5, and the driving transistor T5 may be a metal oxide transistor. At least a part of the other transistors may also be metal oxide transistors. Alternatively, only the driving transistor T5 is the metal oxide transistor. Metal oxide transistors refer to those whose active layer material is IGZO (Indium Gallium Zinc Oxide), IZO (Indium Zinc Oxide), and the like. The active layer of the transistor includes a channel and a conductor part connected to the channel.

Each transistor may include a gate, a first terminal and a second terminal. By controlling the voltage of the gate, the conduction and disconnection between the first terminal and the second terminal can be achieved. The first terminal may be a source, and the second terminal can be a drain. Alternatively, the first terminal may be a drain, and the second terminal may be a source. Specifically, if a signal is input from the first terminal, the first terminal is a source, and the second terminal is a drain; if a signal is input from the second terminal, the second terminal is a source, and the first terminal is a drain; that is, the source and the drain can be interchanged according to the change of the input signal.

For a P-type transistor, when the gate receives a high level, the first terminal and the second terminal are disconnected; when the gate receives a low level, the first terminal and the second terminal are conducted. For an N-type transistor, when the gate receives a high level, the first terminal and the second terminal are conducted; when the gate receives a low level, the first terminal and the second terminal are disconnected.

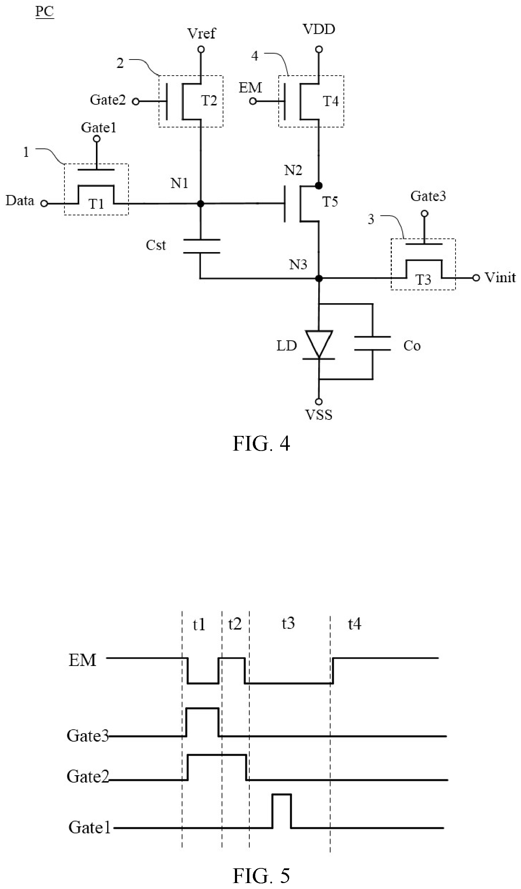

Taking one pixel circuit PC as an example, as shown in FIG. 4, the pixel circuit PC may include a driving transistor T5, a write circuit 1, a first reset circuit 2, a second reset circuit 3 and a light emission control circuit 4.

The first reset circuit 2 is connected to the gate of the driving transistor T5, and the first reset circuit 2 may be turned on or off in response to the first reset scan signal Gate2. The first reset circuit 2 may receive the first reset signal Vref and can transmit the first reset signal Vref when turned on.

The second reset circuit 3 is connected to the first terminal of the driving transistor T5, and the second reset circuit 3 may be turned on or off in response to the second reset scan signal Gate3. The second reset circuit 3 may receive the second reset signal Vinit and may transmit the second reset signal Vinit when turned on.

The write circuit 1 is connected to the gate of the driving transistor T5, and the write circuit 1 may be turned on or off in response to the write scan signal Gate1. The write circuit 1 may receive the data signal Data and may transmit the data signal Data when turned on.

The light emission control circuit 4 may receive the first power signal VDD and is connected to the second terminal of the driving transistor T5. The light emission control circuit 4 may be turned on or off in response to the light emission control signal EM, and when turned on, may transmit the first power signal VDD to the driving transistor T5. The storage capacitor Cst is connected to the gate and the first terminal of the driving transistor T5.

Further, in some embodiments of the present disclosure, as shown in FIG. 1, FIG. 4, FIG. 11 and FIG. 12, the pixel circuit PC is a 5T1C structure, that is, five transistors and one capacitor. Specifically, the first reset circuit 2 includes a first reset transistor T2, the second reset circuit 3 includes a second reset transistor T3, the write circuit 1 includes a write transistor T1, and the light emission control circuit 4 includes a light emission control transistor T4; all transistors in the pixel circuit PC are metal oxide transistors. Meanwhile, to facilitate signal transmission, the driving backplane BP may further include a first power line VDL, a data line DAL, a first reset scan line GL2, a second reset scan line GL3, a write scan line GL1, a light emission control line EML, a first reset signal line VRL and a second reset signal line VIL. The first power line VDL and the data line DAL may extend along the column direction Y and be distributed along the row direction X. The first reset scan line GL2, the second reset scan line GL3, the write scan line GL1, the light emission control line EML, the first reset signal line VRL and the second reset signal line VIL may extend along the row direction X and be distributed along the column direction Y.

The first reset scan line GL2 is connected to the gate of the first reset transistor T2 and is used for transmitting the first reset scan signal Gate2. The first reset signal line VRL is connected to the first terminal of the first reset transistor T2 and may transmit the first reset signal Vref. The second terminal of the first reset transistor T2 is connected to the gate of the driving transistor T5 and is connected to the N1 node. The first reset scan signal Gate2 may be used for controlling the first reset transistor T2 to be turned on or off, and when the first reset transistor T2 is turned on, the first reset signal Vref may be transmitted to the gate of the driving transistor T5 through the first reset transistor T2, that is, to the N1 node.

The second reset scan line GL3 is connected to the gate of the second reset transistor T3 and is used for transmitting the second reset scan signal Gate3; the second reset signal line VIL is connected to the first terminal of the second reset transistor T3 and may transmit the second reset signal Vinit. The second terminal of the second reset transistor T3 is connected to the first terminal of the driving transistor T5 and may be connected to the N3 node. The second reset scan signal Gate3 may be used for controlling the second reset transistor T3 to be turned on or off, and when the second reset transistor T3 is turned on, the second reset signal Vinit may be transmitted to the first terminal of the driving transistor T5 through the second reset transistor T3, that is, to the N3 node.

The light emission control line EML is connected to the gate of the light emission control transistor T4 for transmitting the light emission control signal EM. The first power line VDL is connected to the first terminal of the light emission control transistor T4, and the second terminal of the light emission control transistor T4 is connected to the second terminal of the driving transistor T5 and may be connected to the N2 node. The first power line VDL is used for transmitting the first power signal VDD. The light emission control transistor T4 can be turned on or off based on the light emission control signal EM, and when the light emission control transistor T4 is turned on, the first power signal VDD may be transmitted to the second terminal of the driving transistor T5 through the light emission control transistor T4.

The write scan line GL1 is connected to the gate of the write transistor T1 for transmitting the write scan signal Gate1. The data line DAL is connected to the first terminal of the write transistor T1 and may transmit the data signal Data. The second terminal of the write transistor T1 is connected to the gate of the driving transistor T5 and may be connected to the N1 node. The write transistor T1 may be turned on or off based on the write scan signal Gate1, and when the write transistor T1 is turned on, the data signal Data can be transmitted to the gate of the driving transistor T5 through the write transistor T1, that is, to the N1 node.

The storage capacitor Cst has a first plate Cst1 and a second plate Cst2 arranged oppositely. The first plate Cst1 is connected to the first terminal of the driving transistor T5 and may be connected to the N3 node. The second plate Cst2 is connected to the gate of the driving transistor T5 and can be connected to the N1 node. The first terminal of the driving transistor T5 and the second terminal of the second reset transistor T3 can be connected to the first electrode ANO of the light emission device and can be connected to the N3 node.

In some embodiments of the present disclosure, as shown in FIG. 1, FIG. 11 and FIG. 12, the driving backplane BP further includes a second power line VSL, a first auxiliary power line VDLs and a second auxiliary power line VSLs.

The second power line VSL may extend along the column direction Y and the number of the second power line VSL may be multiple, and may be distributed along the row direction X. Alternatively, the number of the second power line VSL may be one. The second power line VSL is used for transmitting the second power signal VSS and may be connected to the second electrode of the light emission device. For example, the driving backplane BP has a first power bus used for transmitting the first power signal VDD and a second power bus used for transmitting the second power signal VSS in the peripheral area. Each first power line VDL may be connected to the first power bus, while the second power line VSL can be connected to the second power bus. The second electrode of the light emission device can extend to the peripheral area and be directly or indirectly connected to the second power bus. The second power line VSL and the second power bus may be collectively used for transmitting the second power signal VSS. While the second power signal VSS can be transmitted to the second electrode through the second power bus, the second power line VSL can be used for reducing resistance and decreasing voltage drop, thereby facilitating to maintain signal stability and uniformity. In some embodiments, the second power line VSL may not be provided.

The first auxiliary power line VDLs may extend along the row direction X, the number of which may be multiple, and they may be distributed along the column direction Y. Alternatively, the first auxiliary power line may be only one. The first auxiliary power line VDLs may cross with the first power line VDL in space but be located on different layers, and may be connected through contact hole, so that the first auxiliary power line VDLs and the first power line VDL form a network for transmitting the first power signal VDD, thereby being beneficial for reducing resistance, minimizing voltage drop, and maintaining signal stability and uniformity.

The second power line VSL may extend along the row direction X, the number of which may be multiple, and they may be distributed along the column direction Y. Alternatively, the second power line VSL may be only one. The second auxiliary power line VSLs may cross with the second power line VSL in space but be located on different layers, and may be connected through contact hole, so that the second auxiliary power line VSLs and the second power line VSL form a network for transmitting the second power signal VSS, thereby being beneficial for reducing resistance, minimizing voltage drop, and maintaining signal stability and uniformity.

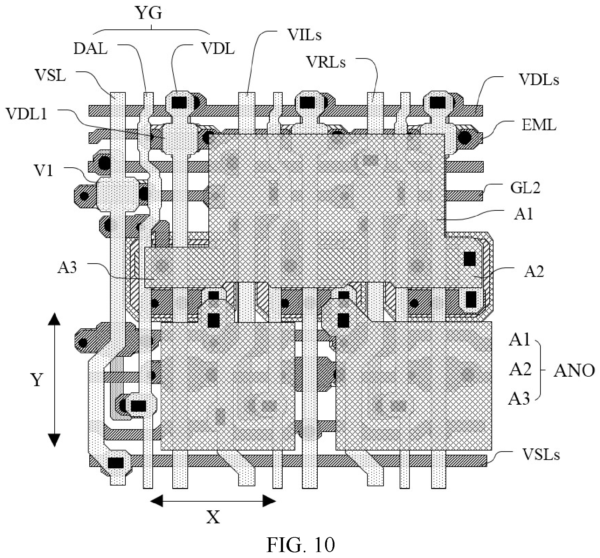

Further, in some embodiments of the present disclosure, as shown in FIG. 10 to FIG. 12, the driving backplane BP further includes the first auxiliary reset line VRLs extending along the column direction Y, the number of which may be multiple, and they may be distributed along the column direction Y. Alternatively, the first auxiliary reset line VRLs may be only one. The first auxiliary reset line VRLs and the first reset signal line VRL are located on different layers and are connected through contact hole, so as to form a network for transmitting the first reset signal Vref, thereby being beneficial for reducing resistance, minimizing voltage drop, and maintaining signal stability and uniformity.

Further, in some embodiments of the present disclosure, as shown in FIG. 10 to FIG. 12, the driving backplane BP further includes the second auxiliary reset line VILs extending along the column direction Y, the number of which may be multiple, and they may be distributed along the column direction Y. Alternatively, the second auxiliary reset line VILs may be only one. The second auxiliary reset line VILs and the second reset signal line VIL are located on different layers and are connected through contact hole, so as to form a network for transmitting the second reset signal Vinit, thereby being beneficial for reducing resistance, minimizing voltage drop, and maintaining signal stability and uniformity.

The following provides an exemplary description of the distribution of the above-mentioned lines.

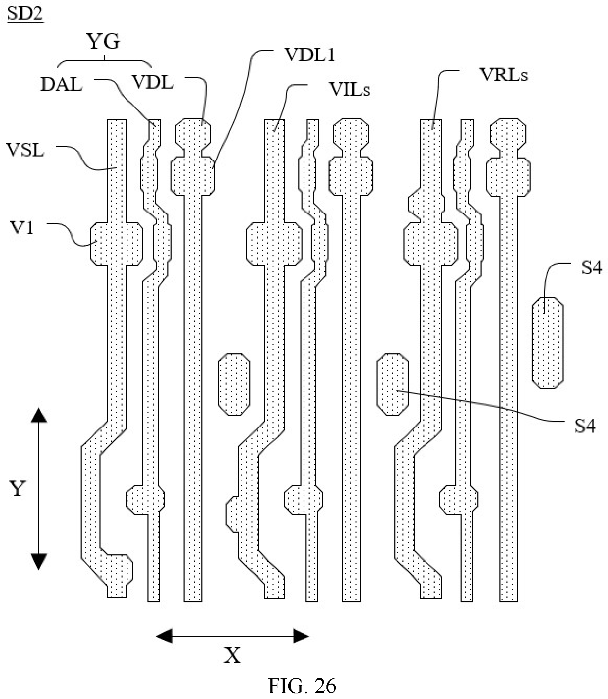

In some embodiments of the present disclosure, as shown in FIG. 1, FIG. 11 and FIG. 26, one data line DAL is connected to the write transistor T1 corresponding to one column of pixel circuits PC; one first power line VDL is connected to the light emission control transistor T4 corresponding to one column of pixel circuits PC. The data line DAL and the first power line VDL connected to the same column of pixel circuits PC can be defined as one column line group YG, that is, each column of pixel circuits PC can be connected to one column line group YG. One of the second power line VSL, the first auxiliary reset line VRLs and the second auxiliary reset line VILs may be provided between two adjacent column line groups YG, that is, the second power line VSL, the first auxiliary reset line VRLs and the second auxiliary reset line VILs are distributed in the space between the column line groups YG. Two of the second power line VSL, the first auxiliary reset line VRLs and the second auxiliary reset line VILs are provided on both sides of the same column line group YG. Thus, the space can be fully utilized, and the distribution of the lines in the column direction Y can be more uniform.

For example, as shown in FIG. 1, FIG. 11 and FIG. 26, the second power line VSL, the first auxiliary reset line VRLs and the second auxiliary reset line VILs may all be defined as auxiliary lines. The auxiliary lines can be alternately distributed with the above-mentioned column line groups YG along the row direction X. In the row direction X, if the n-th auxiliary line is the second power line VSL, then the (n+1)-th auxiliary line is the second auxiliary reset line VILs, and the (n+2)-th auxiliary line is the first auxiliary reset line VRLs, where n is a positive integer. The auxiliary lines can also be arranged in other sequences, and will not be elaborated here.

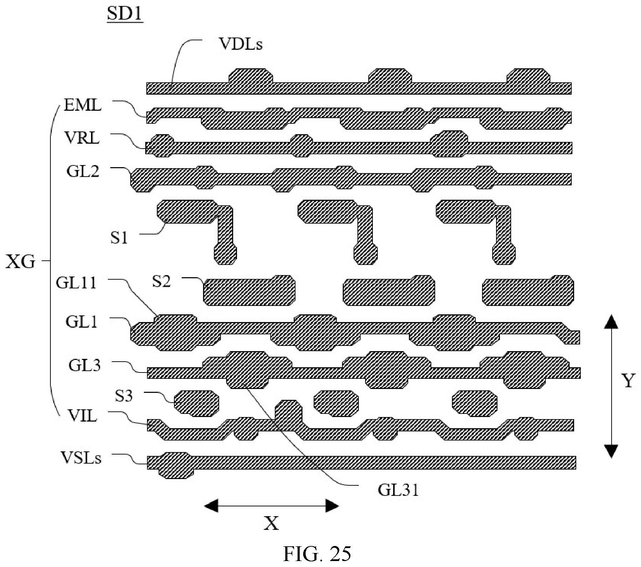

In some embodiments of the present disclosure, as shown in FIG. 1, FIG. 12 and FIG. 25, one row of pixel circuits PC is connected to one first reset scan line GL2, one second reset scan line GL3, one write scan line GL1, one light emission control line EML, one first reset signal line VRL and one second reset signal line VIL. The specific connection relationship has been described in the above content about the pixel circuit PC and will not be repeated here. The first reset scan line GL2, the second reset scan line GL3, the write scan line GL1, the light emission control line EML, the first reset signal line VRL and the second reset signal line VIL connected to the same row of pixel circuits PC may be defined as a row line group XG, that is, each row of pixel circuits PC is connected to one row line group XG. One first auxiliary power line VDLs and one second auxiliary power line VSLs may be provided between two adjacent row line groups XG. One row line group XG is located between one first auxiliary power line VDLs and one second auxiliary power line VSLs.

Based on the structure of the pixel circuit PC according to the foregoing embodiments, a driving method of the pixel circuit PC will be described below.

As shown in FIG. 4, taking a pixel circuit PC in the 5T1C structure as an example, all transistors are metal oxide transistors and N-type transistors. As shown in FIG. 5, the driving method of the present disclosure may include the following.

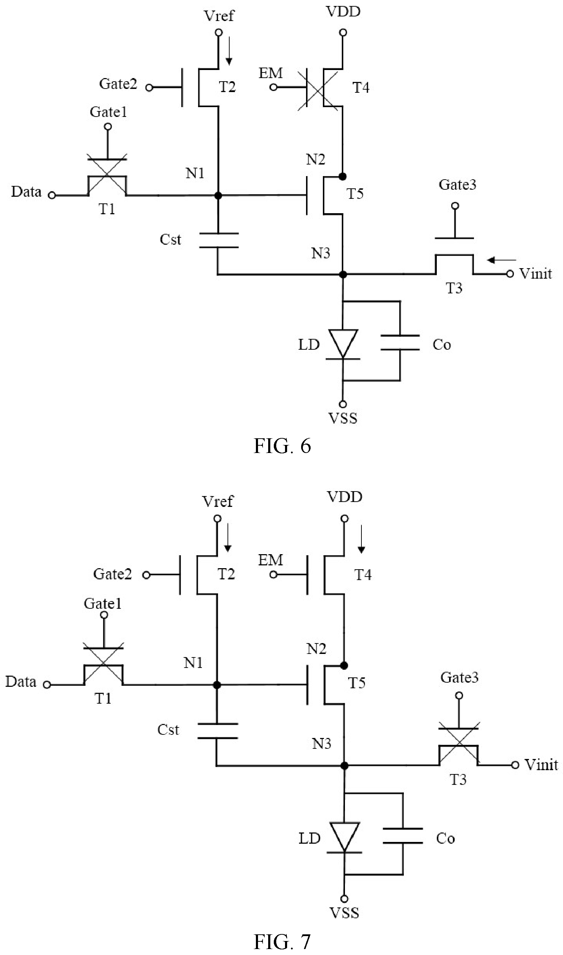

As shown in FIG. 5 and FIG. 6, during the initialization stage t1: the first reset scan signal Gate2 is at a high level, the first reset transistor T2 and the second reset transistor T3 are turned on, the first reset signal Vref is transmitted to the gate of the driving transistor T5, and the second reset signal Vinit is transmitted to the first terminal of the driving transistor T5 and the first electrode ANO of the light emission device, that is, the second reset signal Vinit is transmitted to the N3 node; the write scan signal Gate1 and the light emission control signal EM are at a low level, and the write transistor T1 and the light emission control transistor T4 are turned off. The gate and the first terminal of the driving transistor T5 and the first electrode ANO of the light emission device are initialized based on the first reset signal Vref and the second reset signal Vinit, that is, the N1 node and the N3 node are initialized. At this time, the voltage of the N1 node = Vref, and the voltage of the N3 node = Vinit.

As shown in FIG. 5 and FIG. 7, during the compensation stage t2: the first reset scan signal Gate2 remains at a high level, the second reset scan signal Gate3 is at a low level, the first reset transistor T2 remains turned on and transmits the first reset signal Vref to the gate of the driving transistor T5, that is, to the N1 node, while the second reset transistor T3 is turned off. The light emission control signal EM is at a high level, and the light emission control transistor T4 is turned on.

When the voltage difference between the first reset signal Vref and the second reset signal Vinit is greater than the threshold voltage of the driving transistor T5, that is, when the voltage difference between the N1 node and the N3 node is greater than the threshold voltage, the driving transistor T5 is turned on; the first power signal VDD charges the first terminal of the driving transistor T5 until the voltage difference between the first reset signal Vref and the threshold voltage of the driving transistor T5 is reached, that is, until the voltage at the N3 node reaches Vref-Vth, the driving transistor T5 is turned off, thereby writing the threshold voltage to the first terminal of the driving transistor T5. At this time, the voltage at the N1 node = Vref, and the voltage at the N3 node = Vref-Vth.

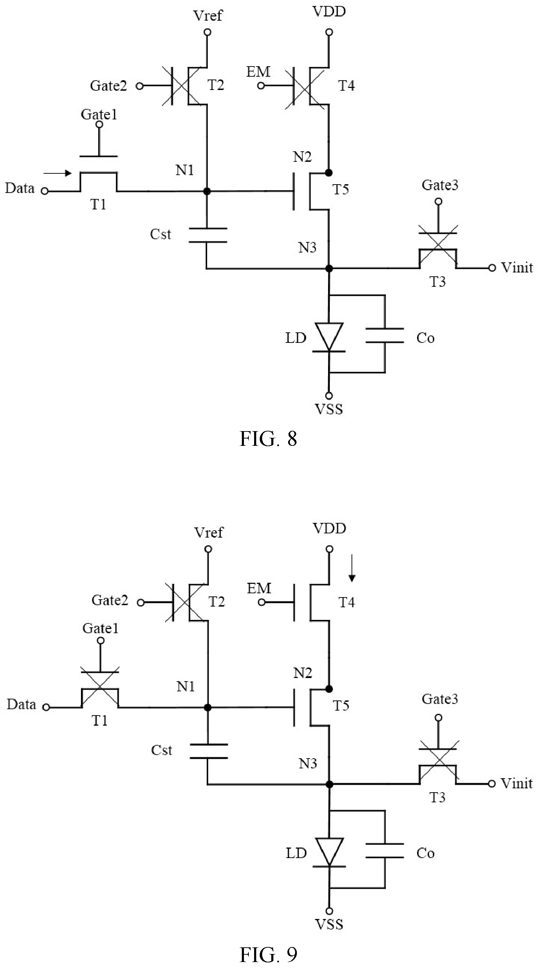

As shown in FIG. 5 and FIG. 8, during the write stage t3, the first reset scan signal Gate2, the second reset scan signal Gate3, and the light emission control signal EM are all at a low level, while the write scan signal Gate1 is at a high level; the first reset transistor T2, the second reset transistor T3, and the light emission control transistor T4 are turned off, and the write transistor T1 is turned on. Data signal Data is written to the N1 node through the write transistor T1, that is, to the gate of the driving transistor T5 and the second plate Cst2 of the storage capacitor Cst. At this time, the voltage Vg at the N1 node = Vdata, and the voltage at the N3 node = Vld + Vss = Vref - Vth, where Vld is the voltage of the light emission device LD, that is, the voltage of the capacitance Co of the light emission device LD.

As shown in FIG. 5 and FIG. 9, during the emission stage t4: the light emission control signal EM is at a high level, the first reset scan signal Gate2, the second reset scan signal Gate3, and the write scan signal Gate1 are all at a low level, then the light emission control transistor T4 is turned on, and the first reset transistor T2, the second reset transistor T3, and the write transistor T1 are turned off. Under the effect of the storage capacitor Cst, the driving transistor T5 outputs current, and the output current satisfies the following formula.

$$I = (\mu WCox/2L)(Vgs - Vth)^2.$$

I is the output current of the driving transistor T5; $\mu$ is the carrier mobility; Cox is the unit area gate capacitance; W is the channel width of the driving transistor T5; and L is the channel length of the driving transistor T5.

According to the above formula of the output current, substituting the voltage difference Vgs between the gate voltage and the source voltage of the driving transistor T5 in the pixel circuit PC of the present disclosure in the formula yields: the output current I of the

$$\text{driving transistor T5} = (\mu WCox/2L)(Vgs - Vth)^2$$

$$= (\mu WCox/2L)(Vdata - (Vld + VSS) - (Vref - Vld - VSS))^2$$

$$= (\mu WCox/2L)(Vdata - (Vref - Vth) - Vth)^2$$

$$= (\mu WCox/2L)(Vdata - Vref)^2$$

It can be seen that the threshold voltage compensation stage and the data signal Data write stage are carried out separately. The output current (that is, the current of the light emission device) depends only on Vdata and Vref, rather than being affected by the voltage of the first power signal VDD and the threshold voltage Vth. The current of the first reset signal Vref is smaller than that of the first power signal VDD, and the IR Drop (voltage drop) risk is small.

In other embodiments of the present disclosure, at least some of the transistors other than the driving transistor T5 may be P-type transistors, and the material of the P-type transistors channel parts may be polycrystalline silicon. The P-type transistors may be turned on at low levels and turned off at high levels.

The following describes the film layers of the driving backplane BP based on the above pixel circuit PC.

As shown in FIG. 2 and FIG. 3, the driving backplane BP includes a substrate SU, a semiconductor layer SE, and at least one source-drain layer.

The substrate SU may be made of material such as glass or polyimide, and provides a supporting function. The structure of the substrate SU may be a single-layer structure or multi-layer structure, which is not particularly limited here.

The semiconductor layer SE is located on one side of the substrate SU, and at least part of the channel parts of the transistors are located in the semiconductor layer SE. For example, if all the transistors are metal oxide transistors, the material of the semiconductor layer SE is metal oxide, and the channel parts of all the transistors are located in the semiconductor layer SE. If both metal oxide transistors and transistors with channel parts made of polycrystalline silicon or other materials are exist, the number of semiconductor layers SE may be multiple, and the channel parts made of different materials may be distributed in different semiconductor layers SE. The present description is only given as an example where all the transistors are metal oxide transistors.

The number of source-drain layer is at least one, for example, the number of source-drain layers may be two. The source-drain layers are located on the side of the semiconductor layer SE away from the substrate SU, and the connection of at least part of the transistors and the transmission of signals can be achieved through the source-drain layers. The structure of each source-drain layer may be a single-layer structure or multi-layer structure, and each layer can be made of conductive materials such as metals or alloys. For example, a source-drain layer can include three sub-layers stacked in sequence along the direction away from the substrate SU, where the material of the middle layer is aluminum and the materials of the other two layers are titanium, thereby forming a titanium/aluminum/titanium structure.

Moreover, the driving backplane BP may further include a gate layer, the gate layer may overlap with the semiconductor layer SE to form a transistor. The area where the semiconductor layer SE overlaps with the gate layer is the channel of the transistor, and the nonoverlapping area may be conductorized to form the first terminal and second terminal of the transistor. The area where the gate layer overlaps with the semiconductor layer SE is the gate of the transistor. For any transistor, the structure thereof may be a top-gate structure, that is, the gate is located between the substrate SU and the semiconductor layer SE; the structure thereof may also be a bottom-gate structure, that is, the gate is located on the side of the semiconductor layer SE away from the substrate SU; or, the structure thereof may also be a top-gate and bottom-gate structure, that is, two gates are provided and respectively located between the substrate SU and the semiconductor layer SE and on the side of the semiconductor layer SE away from the substrate SU, and the two gates further overlap with each other.

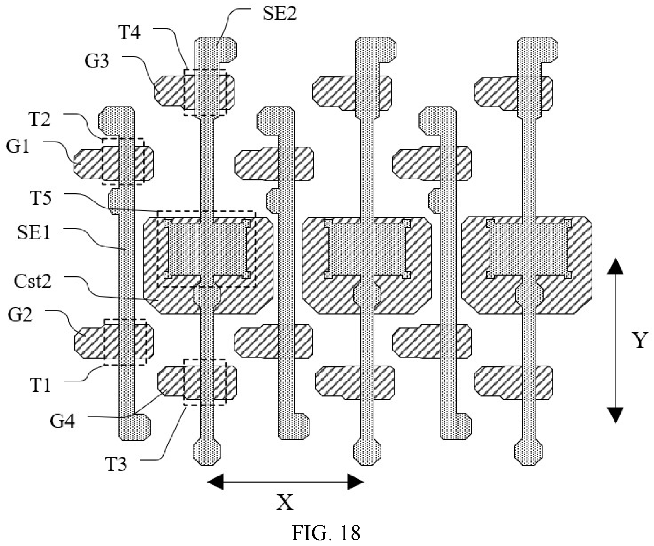

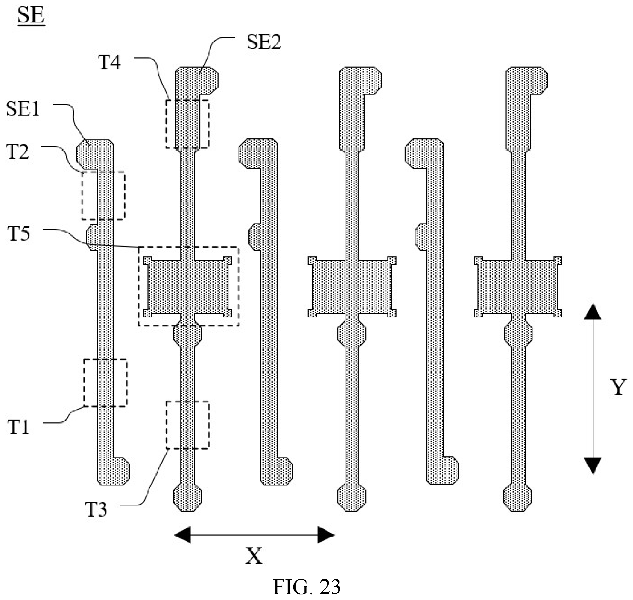

In some embodiments of the present disclosure, as shown in FIG. 2, FIG. 3, FIG. 16 to FIG. 24, the channel parts of each transistor are all located in the same semiconductor layer SE. The driving backplane BP may further include a light-shielding layer BSM, a first gate layer GA1 and a second gate layer GA2.

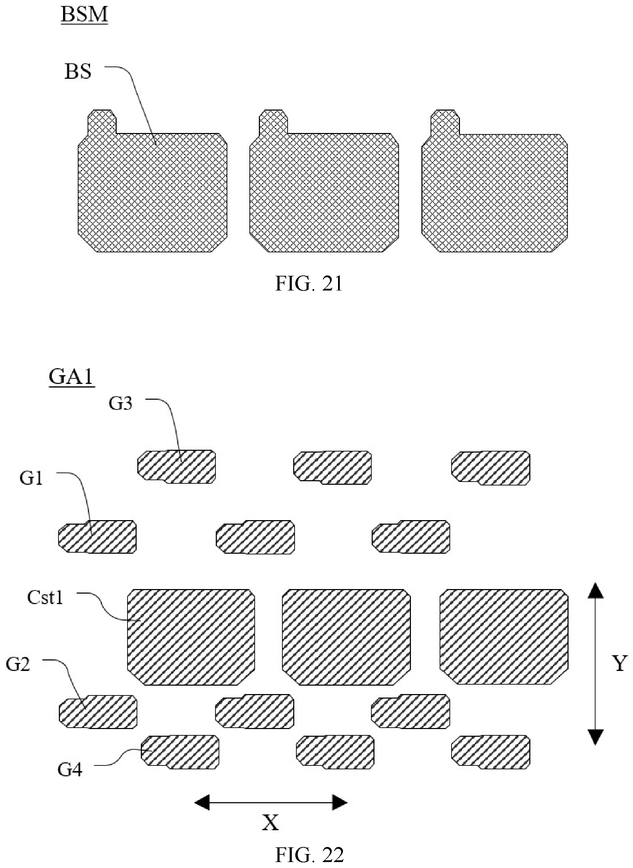

As shown in FIG. 21, the light-shielding layer BSM is located on one side of the substrate SU, and the semiconductor layer SE is located on the side of the light-shielding layer BSM away from the substrate SU. The light-shielding layer BSM may include a plurality of light-shielding parts BS, and the light-shielding parts BS may overlap with the channel part of the driving transistor T5, thereby shading the driving transistor T5 on the side close to the substrate SU and improving the stability of the driving transistor T5.

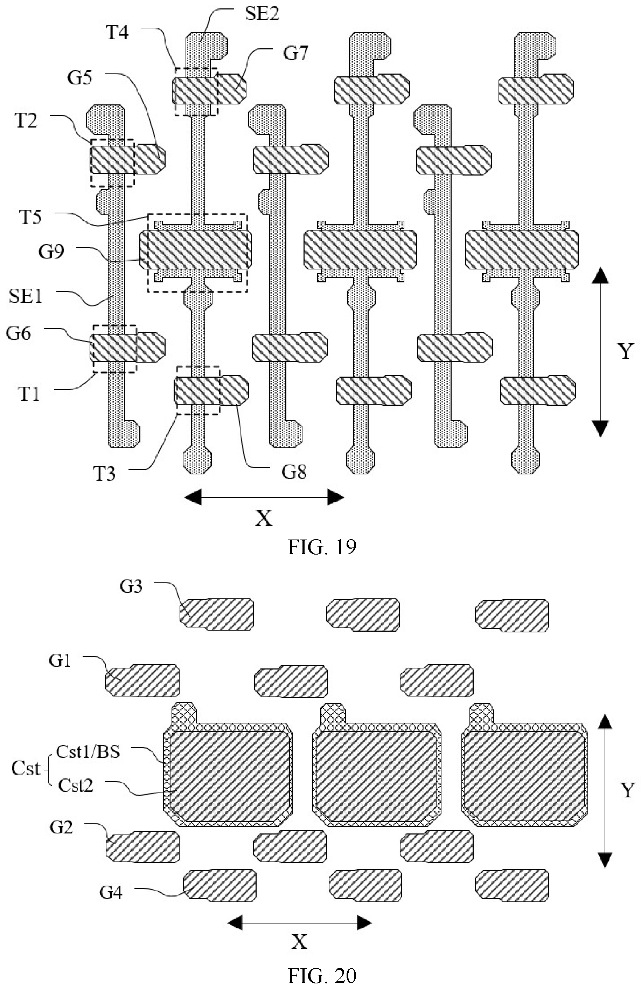

As shown in FIG. 20, the first gate layer GA1 may be located on the side of the light-shielding layer BSM away from the substrate SU, the semiconductor layer SE is located on the side of the first gate layer GA1 away from the substrate SU, and the second gate layer GA2 is located on the side of the semiconductor layer SE away from the substrate SU. The source-drain layer is located on the side of the second gate layer GA2 away from the substrate SU.

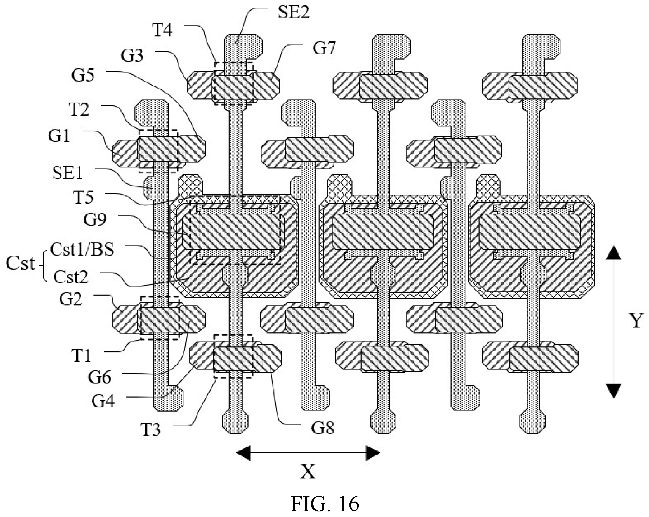

As shown in FIG. 16 and FIG. 20, the light-shielding part BS may be reused as the first electrode plate Cst1 of the storage capacitor Cst, and the first gate layer GA1 includes the second electrode plate Cst2 of the storage capacitor Cst. The first electrode plate Cst1 overlaps with the second electrode plate Cst2. Both the first electrode plate Cst1 and the second electrode plate Cst2 overlap with the channel part of the driving transistor T5. Further, the orthographic projection of the second electrode plate Cst2 on the substrate SU is within the orthographic projection of the first electrode plate Cst1 on the substrate SU, and the orthographic projection of the channel part of the driving transistor T5 on the substrate SU is within the orthographic projection of the light-shielding part BS on the substrate SU.

Further, as shown in FIG. 16 to FIG. 23, the semiconductor layer SE may include a first semiconductor part SE1 and a second semiconductor part SE2 distributed at intervals along the row direction X, and both the first semiconductor part SE1 and the second semiconductor part SE2 extend along the column direction Y. The channel parts of the first reset transistor T2 and the write transistor T1 are arranged along the column direction Y in the first semiconductor part SE1; the channel parts of the light emission control transistor T4, the driving transistor T5 and the second reset transistor T3 are arranged along the column direction Y in the second semiconductor part SE2, and the channel part of the driving transistor T5 is located between the channel parts of the light emission control transistor T4 and the second reset transistor T3. The channel part of the driving transistor T5 protrudes towards both sides of the second semiconductor part SE2 along the row direction X, thereby increasing the width-to-length ratio of the driving transistor T5 and facilitating an increase in the output current.

Each transistor can adopt a structure with a top gate and a bottom gate, and the bottom gate and the top gate are connected to achieve an equal potential, thereby facilitating to improve the stability of the transistor and to obtain a good S.S. (subthreshold swing). The bottom gate of each transistor can be located in the first gate layer GA1, and the top gate of each transistor can be located in the second gate layer GA2.

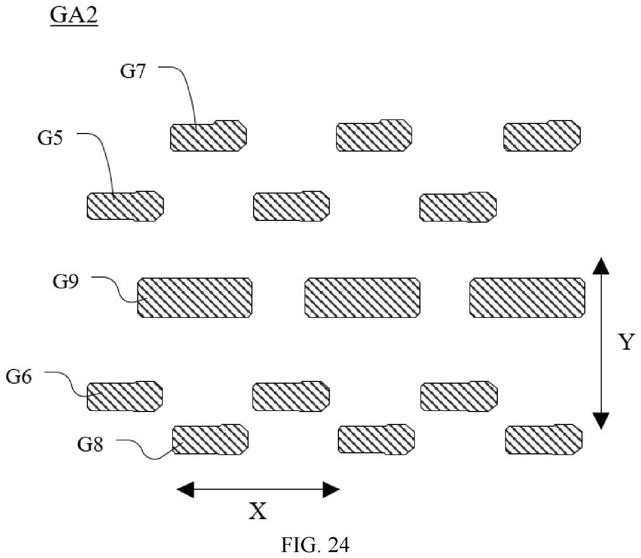

For example, as shown in FIG. 22 and FIG. 24, in addition to the second plate Cst2 of the storage capacitor Cst, the first gate layer GA1 further includes the first gate part G1, the second gate part G2, the third gate part G3 and the fourth gate part G4; the second gate layer GA2 may include the fifth gate part G5, the sixth gate part G6, the seventh gate part G7, the eighth gate part G8 and the ninth gate part G9.

On the basis that both the first semiconductor part SE1 and the second semiconductor part SE2 extend along the column direction Y, the first gate part G1 to the ninth gate part G9 may extend along the row direction X, and the widths thereof in the column direction Y are less than the lengths thereof in the row direction X.

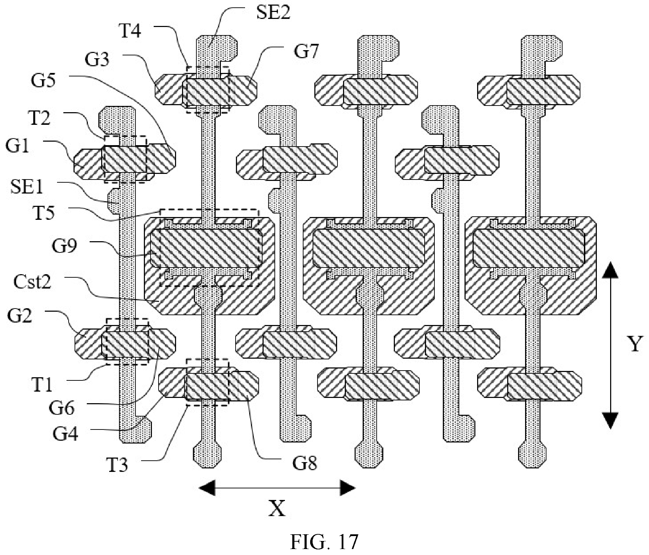

As shown in FIG. 17 to FIG.19, the first gate part G1 and the fifth gate part G5 may overlap with the channel part of the first reset transistor T2, and the first gate part G1 and the fifth gate part G5 are connected. The second gate part G2 and the sixth gate part G6 may overlap with the channel part of the write transistor T1, and the second gate part G2 and the sixth gate part G6 are connected. The third gate part G3 and the seventh gate part G7 may overlap with the channel part of the light emission control transistor T4, and the third gate part G3 and the seventh gate part G7 are connected. The fourth gate part G4 and the eighth gate part G8 overlap with the channel part of the second reset transistor T3, and the fourth gate part G4 and the eighth gate part G8 are connected. The ninth gate part G9 overlaps with the channel part of the driving transistor T5, and the length of the ninth gate part G9 in the row direction X is greater than the width of the channel part of the driving transistor T5 in the row direction X. The orthographic projection of the ninth gate part G9 on the substrate SU is within the orthographic projections of the second plate Cst2 and the light-shielding part BS on the substrate SU, and the ninth gate part G9 serves as the gate of the driving transistor T5.

As shown in FIG. 2, FIG. 10 to FIG. 12, FIG. 25 and FIG. 26, the source-drain layer includes the first source-drain layer SD1 and the second source-drain layer SD2 distributed along the direction away from the substrate SU. The first source-drain layer SD1 is located on the side of the second source-drain layer SD2 away from the substrate SU, and the second source-drain layer SD2 is located on the side of the first source-drain layer SD1 away from the substrate SU. The first reset scan line GL2, the second reset scan line GL3, the write scan line GL1, the light emission control line EML, the first reset signal line VRL, the second reset signal line VIL, the first auxiliary power line VDLs and the second auxiliary power line VSLs as described above are located in the first source-drain layer SD1. The first power line VDL, the second power line VSL, the data line DAL, the first auxiliary reset line VRLs and the second auxiliary reset line VILs are located in the second source-drain layer SD2.

Further, as shown in FIG. 10, FIG. 12 and FIG. 25, the first source-drain layer SD1 may further include a first connection part S1, a second connection part S2 and a third connection part S3.

The first connection part S1 may be respectively connected to the second terminal of the first reset transistor T2 and the gate of the driving transistor T5 through contact hole. For example, one end of the first connection part S1 may be connected to the region, in the first semiconductor part SE1, between the channel parts of the first reset transistor T2 and the write transistor T1 through a contact hole, and the other end may be connected to the ninth gate part G9 through a contact hole.

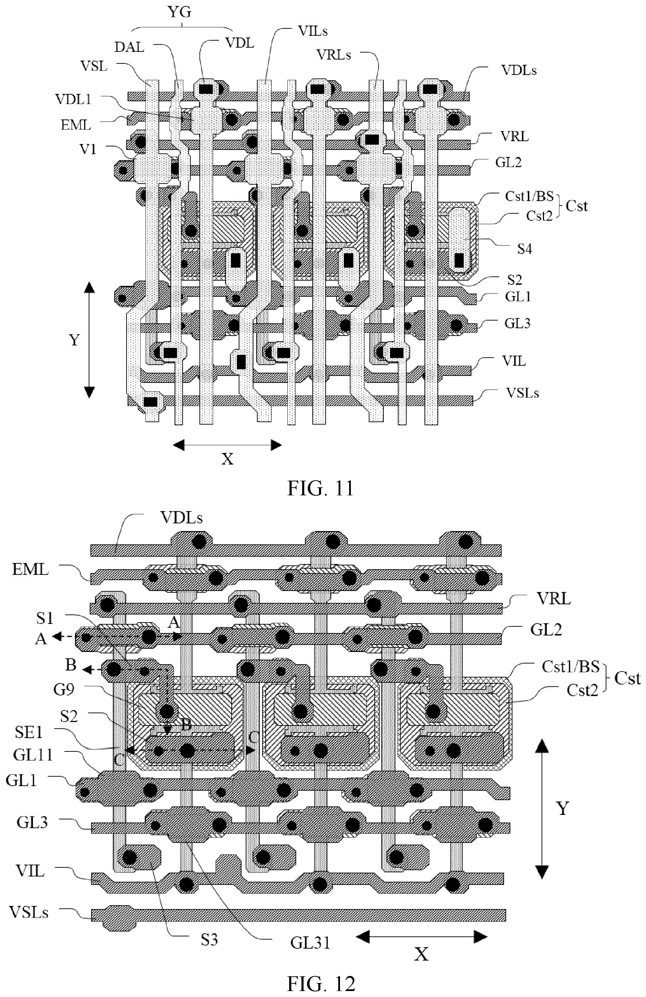

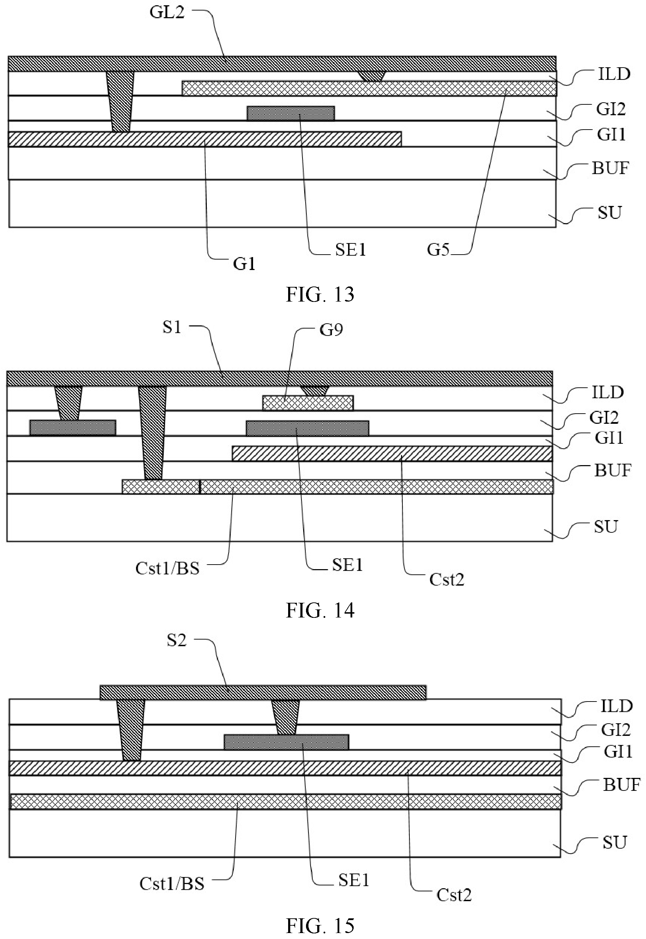

Further, as shown in FIG. 12, FIG. 14 and FIG. 16, the first connection part S1 may extend along a straight line, a broken line or a curved trajectory, as long as it can achieve the aforementioned connection function. For example, the first connection part S1 may include a first connection segment and a second connection segment, where the first connection segment may extend along the row direction X and be located between the first reset scan line GL2 and the ninth gate part G9, and the second connection segment may extend along the column direction Y and be located between the first semiconductor part SE1 and the second semiconductor part SE2. One end of the first connection segment may be connected to the first semiconductor part SE1 between the channel parts of the first reset transistor T2 and the write transistor T1 through a contact hole, the other end of the first connection segment may be connected to one end of the second connection segment, and the other end of the second connection segment may be connected to the ninth gate part G9 through a contact hole.

As shown in FIG. 12, FIG. 15 and FIG. 16, the second connection part S2 may be connected to the second plate Cst2 and the first terminal of the driving transistor T5 through a contact hole. For example, the second connection part S2 may extend along the row direction X and be located between the write scan line GL1 and the first connection part S1, and the orthographic projection of the second connection part S2 on the substrate SU may be located between the orthographic projections of the ninth gate part G9 and the write scan line GL1 on the substrate SU. The orthographic projection of the second connection part S2 on the substrate SU may be located within the orthographic projection of the second plate Cst2 on the substrate SU. The second connection part S2 is respectively connected to the second semiconductor part SE2 between the channel parts of the driving transistor T5 and the second reset transistor T3 and to the second electrode plate Cst2 through contact holes.

The third connection part S3 can be respectively connected to the first electrode of the write transistor T1 and the data line DAL through contact hole to achieve the transmission of the data signal Data. For example, the third connection part S3 is located between the second reset scan line GL3 and the second reset signal line VIL, and is located between the first semiconductor part SE1 and the second semiconductor part SE2. The third connection part S3 is connected to one end of the first semiconductor part SE1 through a contact hole, and this end of the first semiconductor part SE1 is located on the side of the channel part of the write transistor T1 away from the channel part of the first reset transistor T2. The third connection part S3 is further connected to the data line DAL through a contact hole.

Further, as shown in FIG. 10, FIG. 11 and FIG. 26, the second source-drain layer SD2 may further include a transfer part S4, which can be connected to the first terminal of the driving transistor T5 and the second terminal of the second reset transistor T3. For example, the transfer part S4 can be connected to the second connection part S2 through a contact hole. The transfer part S4 can further be connected to the first electrode ANO of the light emission device LD through a contact hole.

In addition, as shown in FIG. 2, the driving backplane BP may further include a first gate insulating layer GI1, a second gate insulating layer GI2, an interlayer dielectric layer ILD, a first planarization layer PLN1, a second planarization layer PLN2, and a buffer layer BUF made of insulating material.

The buffer layer BUF is located on one side of the substrate SU and covers the light-shielding layer BSM. The first gate layer GA1 is located on the surface of the buffer layer BUF away from the substrate SU; the first gate insulating layer GI1 covers the first gate layer GA1; the semiconductor layer SE is located on the surface of the first gate insulating layer GI1 away from the substrate SU; the second gate insulating layer GI2 covers the semiconductor layer SE; the second gate layer GA2 is located on the surface of the second gate insulating layer GI2 away from the substrate SU; the interlayer dielectric layer ILD covers the second gate layer GA2, and the interlayer dielectric layer may be a single-layer structure or a multi-layer structure, for example, the interlayer dielectric layer may include a plurality of dielectric sub-layers stacked in sequence; the first source-drain layer SD1 is located on the surface of the interlayer dielectric layer ILD away from the substrate SU; a passivation layer may be used for covering the first source-drain layer SD1, and then the first planarization layer PLN1 may be used for covering the passivation layer. Alternatively, the passivation layer may not be provided, and the first planarization layer PLN1 may directly cover the first source-drain layer SD1; the second source-drain layer SD2 is located on the surface of the first planarization layer PLN1 away from the substrate SU; the second planarization layer PLN2 covers the second source-drain layer SD2; the first electrode ANO of the light emission device LD is located on the surface of the second planarization layer PLN2 away from the substrate SU and may be separated by the pixel definition layer PDL.

Since the pixel circuit PC contains metal oxide transistors, and the metal oxide semiconductor is easily affected by light, resulting in problems such as threshold voltage shift and low light stability, the source-drain layer can be used to shield at least the metal oxide transistors to reduce the light reaching the metal oxide transistors. Specifically, at least one source-drain layer can be provided to overlap with at least partial channel part of at least partial metal oxide transistors to achieve a shading effect and improve the light stability of the transistors.

For a plurality of source-drain layers, the pattern of the source-drain layer closest to the semiconductor layer SE can be used for shielding to minimize the exposure of the transistor to light. However, considering the limitations of the pattern of a single source-drain layer, the available shielding space is limited. Therefore, a plurality of source-drain layers can be used to shield different metal oxide transistors, reducing the pattern limitations of each source-drain layer and avoiding short-circuit issues. The following is an example where the first source-drain layer SD1 and the second source-drain layer SD2 respectively shield different metal oxide transistors.

In some embodiments of the present disclosure, as shown in FIG. 12, FIG. 16, and FIG. 25, the first source-drain layer SD1 can be used to shield the channel parts of the write transistor T1 and the second reset transistor T3.

For example, the write scan line GL1 overlaps with the channel part of the write transistor T1. The second gate part G2 and the sixth gate part G6 are staggered in the row direction X. The write scan line GL1 overlaps with the second gate part G2 and the sixth gate part G6 and is connected to the second gate part G2 and the sixth gate part G6 through contact hole, allowing the write scan signal Gate1 to be transmitted to both the second gate part G2 and the sixth gate part G6, thereby achieving the connection of the second gate part G2 and the sixth gate part G6.

Further, the boundaries, in the column direction Y, of the orthographic projections of the second gate part G2 and the sixth gate part G6 on the substrate SU may be located within the boundaries, in the column direction Y, of the orthographic projection of the write scan line GL1 on the substrate SU, ensuring that the channel of the write transistor T1 is completely shielded. For example, the write scan line GL1 has write shielding parts GL11 that protrude on both sides along the column direction Y, increasing the width of the write scan line GL1 locally through the write shielding parts GL11, so that the boundaries, in the column direction Y, of the orthographic projections of the second gate part G2 and the sixth gate part G6 on the substrate SU are within the boundaries of the write shielding parts GL11, without increasing the overall width of the write scan line GL1.

The second reset scan line GL3 overlaps with the channel part of the second reset transistor T3. The fourth gate part G4 and the eighth gate part G8 are staggered in the row direction X. The second reset scan line overlaps with the fourth gate part G4 and the eighth gate part G8, and is respectively connected to the fourth gate part G4 and the eighth gate part G8 through contact hole, therey allowing the second reset scan signal Gate3 to be transmitted to both the fourth gate part G4 and the eighth gate part G8, and achieving the connection of the fourth gate part G4 and the eighth gate part G8.

Further, the boundaries, in the column direction Y, of the orthographic projections of the fourth gate part G4 and the eighth gate part G8 on the substrate SU are located within the boundary, in the column direction Y, of the second reset scan line GL3 on the substrate SU, ensuring that the channel of the second reset transistor T3 is completely shielded. For example, the second reset scan line GL3 has a first reset shielding part GL31 that protrudes outwardly on both sides along the column direction Y, and the width of the second reset scan line GL3 can be locally increased through the first reset shielding part, so that the boundaries, in the column direction Y, of the second gate part G2 and the sixth gate part G6 on the substrate SU are located within the boundary, in the column direction Y, of the write shielding part GL11 on the substrate SU, without increasing the overall width of the write scan line GL1.

In the above embodiments, through the shielding of the write scan line GL1 and the second reset scan line GL3 on the write transistor T1 and the second reset transistor T3, since the top gate and the bottom gate of the write transistor T1 are connected and the top gate and the bottom gate of the second reset transistor T3 are connected, and thus having the same potential, the write scan line GL1 and the second reset scan line GL3 transmitting signals to the gates of the write transistor T1 and the second reset transistor T3 will not increase the capacitance at the shielding position.

In some embodiments of the present disclosure, as shown in FIG. 11, FIG. 16 and FIG. 26, the second source-drain layer SD2 can be used to shield the channel parts of the first reset transistor T2 and the light emission control transistor T4.

For example, as shown in FIG. 12, FIG. 13 and FIG. 16, the first reset scan line GL2 overlaps with the first gate part G1 and the fifth gate part G5; the first gate part G1 and the fifth gate part G5 are staggered in the row direction X, and the first reset scan line GL2 overlaps with the first gate part G1 and the fifth gate part G5, and is respectively connected to the first gate part G1 and the fifth gate part G5 through contact hole, so that the first reset scan signal Gate2 can be transmitted to both the first gate part G1 and the fifth gate part G5, and the connection between the first gate part G1 and the fifth gate part G5 is also achieved.

Further, the boundaries, in the column direction Y, of the orthographic projections of the first gate part G1 and the fifth gate part G5 on the substrate SU are located within the boundary, in the column direction Y, of the orthographic projection of one of the second power line VSL, the first auxiliary reset line VRLs and the second auxiliary reset line VILs on the substrate SU, ensuring that the channel of the first reset transistor T2 is completely shielded. For example, one of the second power line VSL, the first auxiliary reset line VRLs and the second auxiliary reset line VILs has a second reset shielding part V1 that protrudes outward in both directions along the row direction X, and the width of one of the second power line VSL, the first auxiliary reset line VRLs and the second auxiliary reset line VILs can be locally increased through the second reset shielding part V1, so that the boundaries, in the column direction Y, of the orthographic projections of the first gate part G1 and the fifth gate part G5 on the substrate SU are located within the boundary, in the column direction Y, of the orthographic projection of the second reset shielding part V1 on the substrate SU, without increasing the overall width of one of the second power line VSL, the first auxiliary reset line VRLs and the second auxiliary reset line VILs.

The light emission control line EML overlaps with the channel part of the light emission control transistor T4. The third gate part G3 and the seventh gate part G7 are staggered in the row direction X. The light emission control line EML overlaps with the third gate part G3 and the seventh gate part G7 and is respectively connected to the third gate part G3 and the seventh gate part G7 through contact holes, so that the light emission control signal EM can be transmitted to both the third gate part G3 and the seventh gate part G7, and the connection between the third gate part G3 and the seventh gate part G7 is also achieved.

Further, the boundaries, in the column direction Y, of the orthographic projections of the third gate part G3 and the seventh gate part G7 on the substrate SU are located within the boundary, in the column direction Y, of the first power line VDL on the substrate SU, ensuring that the channel of the light emission control transistor T4 is completely shielded. For example, the first power line VDL has power shielding parts VDL1 protruding on both sides along the row direction X. The boundaries, in the column direction Y, of the orthographic projections of the third gate part G3 and the seventh gate part G7 on the substrate SU are located within the boundary, in the column direction Y, of the power shielding parts VDL1 on the substrate SU. The width of the first power line VDL can be locally increased through the power shielding parts VDL1, so as to shield the third gate part G3 and the seventh gate part G7 without increasing the overall width of the first power line VDL.

In some embodiments of the present disclosure, the first power line VDL and the second semiconductor part SE2 both extend in the column direction Y. The first power line VDL can be used to shield the second semiconductor part SE2, so that the first power line VDL overlaps with the channel parts of the second reset transistor T3, the driving transistor T5, and the light emission control transistor T4.

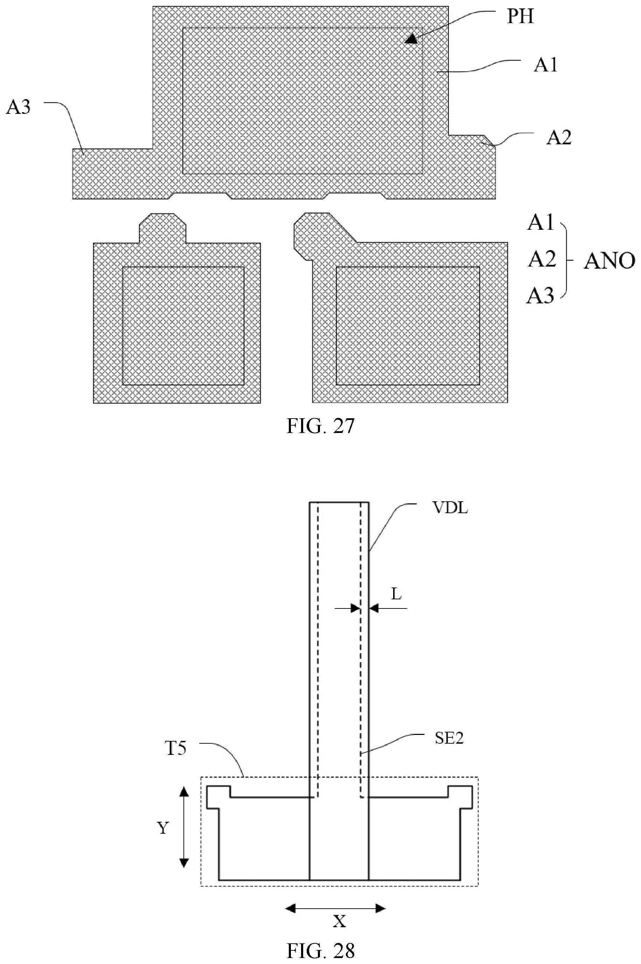

Further, as shown in FIG. 11 and FIG. 28, the boundary, in the row direction X, of the orthographic projection of at least a partial are of the second semiconductor part SE2 on the substrate SU is located within the boundary, in the row direction X, of the orthographic projection of the first power line VDL on the substrate SU, so as to increase the shielding range and to reduce the light incident on the second semiconductor part SE2. For example, the boundary, in the row direction X, of the at least partial area of the second semiconductor part SE2 on the substrate SU is the first boundary, and the boundary, in the row direction X, of the first power line VDL on the substrate SU is the second boundary. The first boundary is located inside the second boundary, and the distance L between the first boundary and the second boundary is less than 2 μm. Further, the distance L between the first boundary and the second boundary may be less than 1 μm, so as to ensure the shielding effect while avoiding the width of the first power line VDL from being too large and interfering with other lines. Alternatively, the first boundary may overlap with the second boundary, as long as the first boundary is not outside the second boundary.

The first boundary mentioned above may at least include the boundary of the orthographic projection, on the substrate SU, of a portion of the second semiconductor part SE2 located between the channel part of the light emission control transistor T4 and the channel part of the driving transistor T5, as well as the boundary of the orthographic projection, on the substrate SU, of a portion thereof between the channel part of the driving transistor T5 and the channel part of the second reset transistor T3. To ensure the aspect ratio of the channel of the driving transistor T5, the boundary, in the row direction X, of the orthographic projection of the channel part of the driving transistor T5 on the substrate SU may be located outside the boundary, in the row direction X, of the orthographic projection of the first power line VDL on the substrate SU.

For the channel part of the driving transistor T5, it can be shielded by using the first source-drain layer SD1. However, the first source-drain layer SD1 is relatively close to the driving transistor T5, a relatively large parasitic capacitance may be caused. Therefore, the second source-drain layer SD2 can be utilized. For example, the orthographic projection of the channel part of the driving transistor T5 on the substrate SU can be located within the orthographic projection of the first power line VDL on the substrate SU through, for example, increasing the overall or partial width of the first power line VDL. Moreover, to avoid a short circuit between the first power line VDL and the data line DAL, the first electrode ANO can be used to shield the channel part of the driving transistor T5, thereby reducing the light exposure. The first electrode ANO is not only limited to shield the driving transistor T5, but can further be used to shield other metal oxide transistors. The following description is given with the shielding of the driving transistor T5 as an example.

In some embodiments of the present disclosure, as shown in FIG. 10 and FIG. 16, one first electrode ANO at least partially overlaps with the channel part of one driving transistor T5. Further, the orthographic projection of the channel part on the substrate SU may be within the orthographic projection of the first electrode ANO on the substrate SU, thereby achieving shielding by the first electrode ANO. The first electrode ANO may have a single-layer or multi-layer structure, and the material thereof may include alloys or metals such as aluminum and titanium, as long as it can shield light and conduct electricity.

Further, in some embodiments of the present disclosure, as shown in FIG. 10 and FIG. 27, the first electrode ANO can include an electrode body A1 and a connection extension part A2 connected to the edge of the electrode body A1. One connection extension part A2 is connected to the first terminal of one driving transistor T5 through a contact hole. The boundary of the orthographic projection of the pixel opening PH on the substrate SU may be within the boundary of the electrode body A1 of the first electrode ANO exposed by the pixel opening PH. The electrode body A1 within the pixel opening PH is stacked with the light emission layer to form the light emission device, while the first electrode ANO outside the pixel opening PH is stacked with the pixel definition layer PDL. By connecting the connection extension part A2 to the contact hole, the electrode body A1 can remain flat, especially the electrode body A1 within the pixel opening PH can remain flat without being connected to the contact hole, thereby avoiding the contact hole from affecting the light emission of the light emission device.

In some embodiments of the present disclosure, as shown in FIG. 10 and FIG. 27, the area of the first electrode ANO can be increased to cover the channel part of the driving transistor T5. However, the number of the first electrodes ANO is great and the space is limited, the area can be increased by extending a local part of the first electrode ANO outwardly, thereby shielding the channel part of the driving transistor T5. Specifically, at least a part of the first electrode ANO may include a shielding extension part A3 connected to the edge of the electrode body A1, and the shielding extension part A3 may overlap with the channel part of the driving transistor T5. For example, the orthographic projection of at least a part of the channel part of the driving transistor T5 on the substrate SU is located within the orthographic projection of the shielding extension part A3 on the substrate SU, thereby improving the shading effect.

Further, at least a part of the first electrode ANO may overlap with the channel parts of a plurality of driving transistors T5. That is, one first electrode ANO may cover the channel parts of a plurality of driving transistors T5. For the first electrode ANO and the channel parts of driving transistors T5 covered by it, the shielding extension part A3 may cover partial channel part, the electrode body A1 may further cover partial channel part, and the connection extension part A2 may further cover partial channel part. That is, any area of the first electrode ANO may cover the channel part.

In some embodiments of the present disclosure, the light emission device may include a first light emission device, a second light emission device, and a third light emission device with different light emission colors. The area of the first electrode ANO of the first light emission device is larger than the area of the first electrodes ANO of the second and third light emission devices. For example, the first light emission device may emit blue light, the second light emission device may emit red light, and the third light emission device may emit green light. The first electrode ANO of the first light emission device may overlap with the channel part of the driving transistor T5 to achieve shielding. The second and third light emission devices may be distributed along the row direction X and, as a whole, may be distributed along the column direction Y with respect to the first light emission device. The first electrode ANO of one first light emission device LD1 may cover the channel parts of two, three, or more driving transistors T5 of the pixel circuits PC distributed along the row direction X.

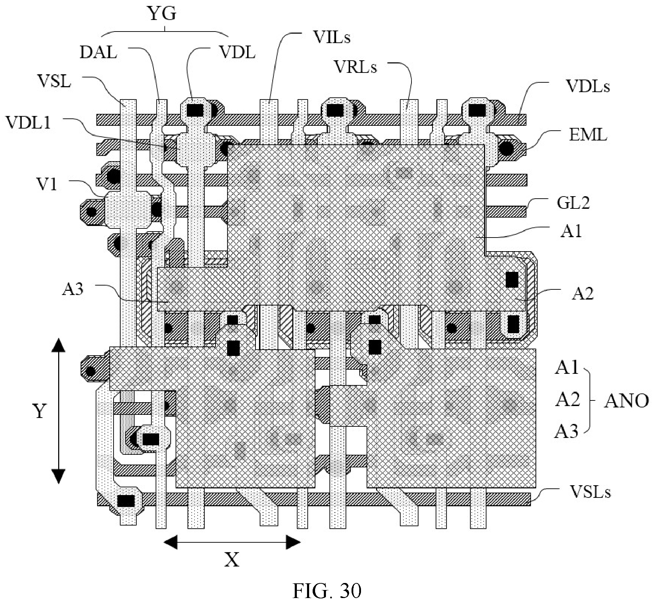

In some other embodiments of the present disclosure, as shown in FIG. 16 and FIG. 30, the first electrodes ANO of the first light emission device, the second light emission device, and the third light emission device may all be provided with the shielding extension part A3. The shielding extension part A3 of the first electrode ANO of the first light emission device may cover the channel part of the driving transistor T5; the shielding extension part A3 of the second light emission device may cover the channel part of the write transistor T1; and the shielding extension part A3 of the third light emission device may cover the channel part of the second reset transistor T3. The positions of the second and third light emission devices can be interchanged. By fully using the first electrodes ANO to cover the channel parts of the transistors, the influence of light on the transistors can be minimized to the greatest extent.

It should be noted that the above embodiments are described with the first electrode ANO covering the channel part of the driving transistor T5, but this does not mean that the first electrode ANO only overlaps with the channel part of the driving transistor T5. The first electrode ANO may further overlap with the channel parts of other transistors. The first electrode ANO overlapping with the channel part of the transistor is not limited to the first light emission device, the second light emission device or third light emission device are also applicable.

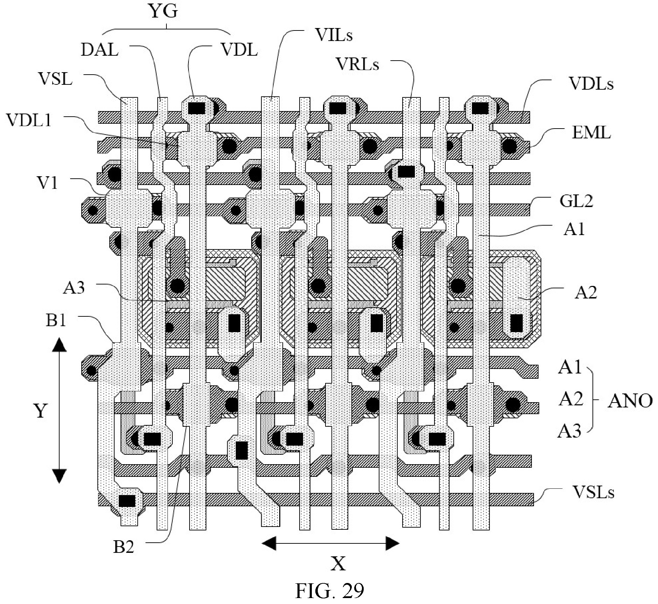

In some embodiments of the present disclosure, the second source-drain layer SD2 may further be used to shield the channels of the write transistor T1 and the second reset transistor T3. For example, as shown in FIG. 29, the second power line VSL, the first auxiliary reset line VRLs, and the second auxiliary reset line VILs may be provided with a first line shielding part B1 protruding in the row direction X. The first line shielding part B1 at least partially overlaps with the channel of the write transistor T1, thereby using the first line shielding part B1 to shield the channel of the write transistor T1 and to reduce the influence of light. The first power line VDL may be provided with a second line shielding part B2 protruding in the row direction X. The second line shielding part B2 at least partially overlaps with the channel of the second reset transistor T3, thereby using the second line shielding part B2 to shield the channel of the second reset transistor T3 and to reduce the influence of light. The second power line VSL, the first auxiliary reset line VRLs, the second auxiliary reset line VILs, and the first power line VDL may further be widened as a whole, as long as no short circuit occurs between the lines.

It should be noted that, as shown in FIG. 10, FIG. 12, FIG. 29, and FIG. 30, for the shielding of the second reset transistor T3 and the write transistor T1, the shielding can be achieved through the first reset shielding part GL31 and the write shielding part GL11 mentioned above, or through the shielding extension part A3, the first line shielding part B1 and the second line shielding part B2 mentioned above, that is, by using the first source-drain layer SD1, the second source-drain layer SD2, and the first electrode ANO for shielding. The above modes can be used simultaneously, that is, using all of the first source-drain layer SD1, the second source-drain layer SD2, and the first electrode ANO for shielding; or only one layer can be used for shielding; or any two layers can be combined, as long as the second reset transistor T3 and the write transistor T1 can be shielded. For example, only one of the first source-drain layer SD1, the second source-drain layer SD2, and the first electrode ANO can be used for shielding; or, the first source-drain layer SD1 and the second source-drain layer SD2 can be used for shielding, and the first electrode ANO may have no shielding extension part A3; or, the first source-drain layer SD1 and the first electrode ANO can be used for shielding, and the second source-drain layer SD2 may have no first line shielding part B1 and second line shielding part B2. In addition, the second reset transistor T3 and the write transistor T1 can further be shielded by different layers, for example, the second reset transistor T3 may be shielded by the shielding extension part A3 and the first reset shielding part GL31, while the write transistor T1 may be shielded by the write shielding part GL11 and the first line shielding part B1. Here, the shielding modes for the second reset transistor T3 and the write transistor T1 will not be elaborated.

Furthermore, compared with the first source-drain layer SD1, the second source-drain layer SD2 and the first electrode ANO are farther from the second gate layer GA2, resulting in smaller parasitic capacitance between the first line shielding part B1, the second line shielding part B2, the shielding extension part A3 and the second gate layer GA2. However, to improve the shielding effect, at least partial boundaries of the orthographic projections of the first line shielding part B1, the second line shielding part B2, and the shielding extension part A3 on the substrate SU can be located outside the boundaries of the orthographic projections, on the substrate SU, of the channels of the transistors shielded by them, and the distance between the boundaries is not less than 2 $\mu$m and may be, for example, 2 $\mu$m to 5 $\mu$m, thereby ensuring the shielding effect while avoiding interference with other structures.

The present disclosure further provides a display device, which may include the display panel according to any of the above embodiments. The display panel is the display panel according to any of the above embodiments, and specific structure of the display panel and beneficial effects thereof can be referred to in the embodiments of the display panel described above, and will not be repeated here. The display device of the present disclosure may be an electronic device such as mobile phone, tablet computer, or television; or a wearable device with image display function such as smart watch, virtual reality device, or augmented reality device; or other electronic devices with display function such as a vehicle-mounted display device; or the like, which will not be elaborated here.

Those skilled in the art will readily conceive of other embodiments of the present disclosure upon considering the specification and practicing the invention disclosed herein. The present application is intended to cover any modifications, uses, or adaptations of the disclosure following the general principles of the present disclosure and including common knowledge or conventional techniques in the technical field of the present disclosure that are not disclosed herein. The specification and examples are merely exemplary, and the true scope and spirit of the present disclosure are indicated by the appended claims.

**Claims**

1.   A display panel, comprising:

   a driving backplane, comprising a plurality of pixel circuits arrayed in a row direction and a column direction, wherein the pixel circuit comprises a plurality of transistors, and a transistor in any of the pixel circuits comprises a driving transistor; the driving transistor in any of the pixel circuits and at least part of the transistors other than the driving transistor are metal oxide transistors; the driving backplane comprises a substrate, and a semiconductor layer and at least one source-drain layer distributed along a direction away from the substrate; a channel part of at least part of the transistors is located in the semiconductor layer; the source-drain layer overlaps with a channel part of at least part of the metal oxide transistors; and
   a light emission device, provided on one side of the driving backplane and comprising a first electrode, a light emission layer and a second electrode distributed along a direction away from the driving backplane; wherein a first terminal of the driving transistor is connected to the first electrode of the light emission device.

2.   The display panel according to claim 1, wherein, the pixel circuit further comprises a storage capacitor, and the transistor in the pixel circuit further comprises a first reset circuit, a second reset circuit, a write circuit and a light emission control circuit;
   the first reset circuit is connected to a gate of the driving transistor, and configured to transmit a first reset signal in response to a first reset scan signal; the second reset circuit is connected to the first terminal of the driving transistor, and configured to transmit a second reset signal in response to a second reset scan signal; the write circuit is connected to the gate of the driving transistor, and configured to transmit a data signal in response to a write scan signal; the light emission control circuit is configured to receive a first power signal, connected to a second terminal of the driving transistor, and configured to be conductive in response to a light emission control signal; and the storage capacitor is connected to the first terminal and the gate of the driving transistor.

3. The display panel according to claim 2, wherein, the driving backplane further comprises a first power line and a data line extending along the column direction, and a first reset scan line, a second reset scan line, a write scan line, a light emission control line, a first reset signal line and a second reset signal line extending along the row direction;

the first reset circuit comprises a first reset transistor, the second reset circuit comprises a second reset transistor, the write circuit comprises a write transistor, and the light emission control circuit comprises a light emission control transistor; all the transistors in the pixel circuit are metal oxide transistors;
the first reset scan line is connected to a gate of the first reset transistor, and configured to transmit the first reset scan signal; the first reset signal line is connected to the gate of the driving transistor through the first reset transistor, and configured to transmit the first reset signal;
the second reset scan line is connected to a gate of the second reset transistor, and configured to transmit the second reset scan signal; the second reset signal line is connected to the first terminal of the driving transistor through the second reset transistor, and configured to transmit the second reset signal;
the first power line is connected to the second terminal of the driving transistor through the light emission control transistor, and configured to transmit the first power signal;
the write scan line is connected to a gate of the write transistor, and configured to transmit the write scan signal; the data line is connected to the gate of the driving transistor through the write transistor, and configured to transmit the data signal;
the light emission control line is connected to a gate of the light emission control transistor, and configured to transmit the light emission control signal.

4. The display panel according to claim 3, wherein, the driving backplane further comprises a second power line extending along the column direction, and a first auxiliary power line and a second auxiliary power line extending along the row direction;

the first auxiliary power line and the first power line are located on different layers and are connected through a contact hole;
the second power line and the second auxiliary power line are located on different layers and are connected through a contact hole; the second power line is connected to the second electrode, and configured to transmit a second power signal.

5. The display panel according to claim 4, wherein, the driving backplane further comprises a first auxiliary reset line extending along the column direction, the first auxiliary reset line and the first reset signal line are located on different layers and are connected through a contact hole.

6. The display panel according to claim 5, wherein, the driving backplane further comprises a second auxiliary reset line extending along the column direction, the second auxiliary reset line and the second reset signal line are located on different layers and are connected through a contact hole.

7. The display panel according to claim 6, wherein, one data line is connected to a write transistor of one column of the pixel circuits; one first power line is connected to a light emission control transistor of one column of the pixel circuits; a data line and a first power line connected to a same column of the pixel circuits are defined as a column line group, wherein one of the second power line, the first auxiliary reset line and the second auxiliary reset line is provided between two adjacent column line groups.

8. The display panel according to claim 5, wherein, one row of the pixel circuits is simultaneously connected to one first reset scan line, one second reset scan line, one write scan line, one light emission control line, one first reset signal line and one second reset signal line;

the first reset scan line, the second reset scan line, the write scan line, the light emission control line, the first reset signal line and the second reset signal line connected to a same row of the pixel circuit are defined as a row line group;

one first auxiliary power line and one second auxiliary power line are provided between two adjacent row line groups.

9. The display panel according to claim 6, wherein, the source-drain layer comprises a first source-drain layer and a second source-drain layer distributed along the direction away from the substrate;
a channel part of the write transistor and a channel part of the second reset transistor overlap with the first source-drain layer; a channel part of the first reset transistor and a channel part of the light emission control transistor overlap with the second source-drain layer.

10. The display panel according to claim 9, wherein, the semiconductor layer comprises a first semiconductor part and a second semiconductor part distributed at intervals along the row direction, and the first semiconductor part and the second semiconductor part extend along the row direction;

a channel part of the first reset transistor and a channel part of the write transistor are located along the column direction in the first semiconductor part; the channel part of the light emission control transistor, the channel part of the driving transistor and the channel part of the second reset transistor are located along the column direction in the second semiconductor part;
the channel part of the write transistor overlaps with one write scan line; the channel part of the second reset transistor overlaps with one second reset scan line;
the first power line overlaps with the channel part of the light emission control transistor, the second reset transistor, and the driving transistor.

11. The display panel according to claim 10, wherein, a boundary, in the row direction, of an orthographic projection of at least a partial region of the second semiconductor part on the substrate is located within a boundary, in the row direction, of an orthographic projection of the first power line on the substrate.

12. The display panel according to claim 11, wherein, the boundary, in the row direction, of the orthographic projection of the at least partial region of the second semiconductor part on the substrate is defined as a first boundary, and the boundary, in the row direction, of the orthographic projection of the first power line on the substrate is defined as a second boundary;
the first boundary is located inside the second boundary, and a distance between the first boundary and the second boundary is less than $2\mu$m.

13. The display panel according to claim 9, wherein, the first reset scan line, the second reset scan line, the write scan line, the light emission control line, the first reset signal line, the second reset signal line, the first auxiliary power line and the second auxiliary power line are located in the first source-drain layer;
the first power line, the second power line, the data line, the first auxiliary reset line and the second auxiliary reset line are located in the second source-drain layer.

14. The display panel according to claim 13, wherein, the driving backplane further comprises:

a light-shielding layer, located on one side of the substrate and comprising a light-shielding part; wherein the semiconductor layer is located on one side of the light-shielding layer away from the substrate, the light-shielding part overlaps with a channel part of the driving transistor, and the light-shielding part is reused as a first terminal plate of the storage capacitor;
a first gate layer, located on the side of the light-shielding layer away from the substrate and comprising a second terminal plate of the storage capacitor; wherein the semiconductor layer is located on one side of the first gate layer away from the substrate, and the first terminal plate overlaps with the channel part of the driving transistor; and
a second gate layer, located on one side of the semiconductor layer away from the substrate and overlapping with the channel part of the driving transistor; wherein the first source-drain layer is located on one side of the second gate layer away from the substrate.

15. The display panel according to claim 14, wherein, the first gate layer further comprises a first gate part, a second gate part, a third gate part and a fourth gate part; the second gate layer comprises a fifth gate part, a sixth gate part, a seventh gate part, an eighth gate part and a ninth gate part;

the first gate part and the fifth gate part overlap with the channel part of the first reset transistor, and the first gate part and the fifth gate part are connected;
the second gate part and the sixth gate part overlap with the channel part of the write transistor, and the second gate part and the sixth gate part are connected;
the third gate part and the seventh gate part overlap with the channel part of the light emission control transistor, and the third gate part and the seventh gate part are connected;
the fourth gate part and the eighth gate part overlap with the channel part of the second reset transistor, and the fourth gate part and the eighth gate part are connected;
the ninth gate part overlaps with the channel part of the driving transistor.

16. The display panel according to claim 15, wherein, a boundary, in the column direction, of an orthographic projection of the first gate part and the fifth gate part on the substrate, is located within a boundary, in the column direction, of an orthographic projection of one of the second power line, the first auxiliary reset line and the second auxiliary reset line on the substrate; and the first gate part and the fifth gate part are connected to the first reset scan line;

a boundary, in the column direction, of an orthographic projection of the third gate part and the seventh gate part on the substrate is within a boundary, in the column direction, of an orthographic projection of the first power line on the substrate; and the third gate part and the seventh gate part are connected to the light emission control line;
a boundary, in the column direction, of an orthographic projection of the second gate part and the sixth gate on the substrate is within a boundary, in the column direction, of an orthographic projection of the write scan line on the substrate; and the second gate part and the sixth gate part are connected to the first reset scan line;
a boundary, in the column direction, of an orthographic projection of the fourth gate part and the eighth gate part on the substrate is within a boundary, in the column direction, of an orthographic projection of the second reset scan line on the substrate; and the fourth gate part and the eighth gate part are connected to the second reset scan line.

17. The display panel according to any one of claims 2 to 16, wherein, one first electrode at least overlaps with a channel part of one of the driving transistors.

18. The display panel according to claim 17, wherein, the first electrode comprises an electrode body and an extension part connected to an edge of the electrode body, wherein one extension part is connected to the first terminal of one of the driving transistors;

at least a part of the first electrodes further comprises an extension part connected to the edge of the electrode body, wherein the extension part overlaps with the channel part of the driving transistor;
the display panel further comprises:
a pixel defining layer, provided on a same side of the driving backplane as the light emission device and having a pixel opening exposing each of the first electrodes; a boundary of an orthographic projection of the pixel opening on the substrate is within a boundary of the electrode body of the first electrode exposed by the pixel opening.

19. The display panel according to claim 17, wherein, at least a part of the first electrode overlaps with channel parts of a plurality of driving transistors.

20. A display device, comprising the display panel according to any one of claims 1 to 19.

FIG. 1

FIG. 2

FIG. 3

FIG. 4

FIG. 5

FIG. 6

FIG. 7

FIG. 8

FIG. 9

FIG. 10

FIG. 11

FIG. 12

GL2

ILD

GI2

GI1

BUF

SU

G1 · SE1 · G5

FIG. 13

S1 · G9

ILD

GI2

GI1

BUF

SU

Cst1/BS · SE1 · Cst2

FIG. 14

S2

ILD

GI2

GI1

BUF

SU

Cst1/BS · SE1 · Cst2

FIG. 15

FIG. 16

FIG. 17

FIG. 18

FIG. 19

FIG. 20

BSM

BS

FIG. 21

GA1

G3

G1

Cst1

G2

Y

G4

X

FIG. 22

FIG. 23

GA2

G7

G5

G9

G6

G8

Y

X

FIG. 24

SD1

VDLs

EML

VRL

GL2

S1

XG

GL11    S2

GL1

GL3

S3

VIL

VSLs

GL31

X

Y

FIG. 25

FIG. 26

FIG. 27

FIG. 28

FIG. 29

FIG. 30

## INTERNATIONAL SEARCH REPORT

| International application No. |
| --- |
| **PCT/CN2024/115594** |

| A. | CLASSIFICATION OF SUBJECT MATTER |
| --- | --- |

H10K59/12(2023.01)i; H10K59/121(2023.01)i; H10K59/131(2023.01)i; H10K59/126(2023.01)i

According to International Patent Classification (IPC) or to both national classification and IPC

| B. | FIELDS SEARCHED |
| --- | --- |

Minimum documentation searched (classification system followed by classification symbols)

IPC: H10K H01L

Documentation searched other than minimum documentation to the extent that such documents are included in the fields searched

Electronic data base consulted during the international search (name of data base and, where practicable, search terms used)

CNABS: CNTXT; CNKI; VEN; EPTXT; USTXT; WOTXT: 源漏, 沟道, 交叠, 重叠, 覆盖, 晶体管, 光照, TFT?, transistor?, light+, overlap+, shield, channel

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 115734657 A (HEFEI BOE ZHUOYIN TECHNOLOGY CO., LTD. et al.) 03 March 2023 (2023-03-03) description, paragraphs [0065]-[0206], and figures 1-15 | 1-3, 20 |
| Y | CN 115734657 A (HEFEI BOE ZHUOYIN TECHNOLOGY CO., LTD. et al.) 03 March 2023 (2023-03-03) description, paragraphs [0065]-[0206], and figures 1-15 | 17-19 |
| A | CN 115734657 A (HEFEI BOE ZHUOYIN TECHNOLOGY CO., LTD. et al.) 03 March 2023 (2023-03-03) description, paragraphs [0065]-[0206], and figures 1-15 | 4-16 |
| Y | CN 113728440 A (BOE TECHNOLOGY GROUP CO., LTD. et al.) 30 November 2021 (2021-11-30) description, paragraphs [0083]-[0339], and figures 1-42 | 17-19 |
| A | CN 116312377 A (WUHAN TIANMA MICRO-ELECTRONICS CO., LTD. et al.) 23 June 2023 (2023-06-23) entire document | 1-20 |

☐ Further documents are listed in the continuation of Box C.     ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **12 October 2024** | **23 October 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2024/115594**

| Patent document<br>cited in search report | | | Publication date<br>(day/month/year) | Patent family member(s) | | | Publication date<br>(day/month/year) |
|---|---|---|---|---|---|---|---|
| CN | 115734657 | A | 03 March 2023 | WO | 2023024870 | A1 | 02 March 2023 |
| | | | | US | 2024078978 | A1 | 07 March 2024 |
| CN | 113728440 | A | 30 November 2021 | EP | 4131404 | A1 | 08 February 2023 |
| | | | | EP | 4131404 | A4 | 11 October 2023 |
| | | | | WO | 2021190508 | A1 | 30 September 2021 |
| | | | | KR | 20220158596 | A | 01 December 2022 |
| | | | | JP | 2023518619 | A | 08 May 2023 |
| | | | | US | 2023422556 | A1 | 28 December 2023 |
| | | | | US | 2022285472 | A1 | 08 September 2022 |
| | | | | US | 11785806 | B2 | 10 October 2023 |
| | | | | US | 2023006019 | A1 | 05 January 2023 |
| | | | | US | 11825697 | B2 | 21 November 2023 |
| | | | | US | 2022320246 | A1 | 06 October 2022 |
| | | | | US | 11825696 | B2 | 21 November 2023 |
| | | | | WO | 2021189304 | A1 | 30 September 2021 |
| CN | 116312377 | A | 23 June 2023 | US | 2023335564 | A1 | 19 October 2023 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311258013